# EUROPEAN PATENT APPLICATION

(11) **EP 2 343 730 A1**
(43) Date of publication of application: **13.07.2011**
(21) Application number: 09816198.7
(22) Date of filing: 25.09.2009
(51) Int. Cl.: H01L 21/027, B29C 59/02, B29K 35/00, B29K 83/00, B29L 11/00

(54) **METHOD FOR CONCAVE AND CONVEX PATTERN FORMATION AND APPARATUS FOR MANUFACTURING CONCAVE AND CONVEX PATTERN**

(30) Priority: 26.09.2008 JP 2008247439
(71) Applicant: Bridgestone Corporation, Tokyo 104-0031 (JP)
(72) Inventor: INAMIYA Takato, Kodaira-Shi Tokyo 187-8531 (JP); KAIDA Eizou, Kodaira-Shi Tokyo 187-8531 (JP)
(74) Representative: Lamb, Martin John Carstairs
(86) International application number: PCT/JP2009/066649
(87) International publication number: WO 2010/035783

(57) **Abstract**

The present invention provides a method for forming concave-convex pattern corresponding to a nanoimprint method which is advantageously utilized in the preparation of electronic devices, optical parts and recording media, and enabling the preparation of the product having the fine pattern mentioned above in cheapness and high speed. The method for forming a concave-convex pattern comprises of the steps: a step of placing and depressing a stamper having a fine concave-convex pattern surface thereon on a photo-curable transfer layer of a photo-curable transfer sheet to form a laminate; a step of exposing the photo-curable transfer layer of the laminate having the stamper to ultraviolet rays to cure the photo-curable transfer layer, and removing the stamper from the laminate to form the inverted fine concave-convex pattern on a surface of the photo-curable transfer layer; a step of placing and depressing the intermediate stamper on a photo-curable transfer layer of another photo-curable transfer sheet to form a laminate; and a step of exposing the photo-curable transfer layer of the laminate having the intermediate stamper to ultraviolet rays to cure the photo-curable transfer layer, and removing the intermediate stamper, whereby the photo-curable transfer sheet having the fine concave-convex pattern surface is obtained.

## Description

### Background of Invention

### Field of the invention

The present invention relates to a method for forming concave-convex pattern and an apparatus for preparing concave-convex pattern by using a photo-curable transfer sheet, the method and apparatus being advantageously utilized in the preparation of electronic devices, optical elements and recording media.

### Description of the Related Art

A microfabrication technology using a light or an electron beam, which is outstandingly developed, enables processing (fabrication) to dimension of approx.100nm by using a light and processing to dimension of approx.10nm by using an electron beam. However, microfabrication devices are expensive, and hence inexpensive microfabrication technology is desired. To fit the purpose, nanoimprint technology is establishing a process for forming a desired circuit pattern on silicon substrate. The nanoimprint technology corresponds to the microfabrication technology enabling the formation of a more fine structure compared with a conventional press technology. The technology has no limit with respect to resolution, and the resolution depends on the accuracy of a prepared mold (steel stamper). Hence, if the mold is accurately prepared, an extremely fine structure can be easily prepared by using a cheap device compared with a conventional photolithography.

The nanoimprint technology is largely divided into two types depending on materials to be transferred. One of the nanoimprint technologies is thermal nanoimprint technology which is carried out by heating material to be transferred, subjecting it to plastic deformation by using a mold, and then cooling it to form pattern. The other of the nanoimprint technologies is photo-nanoimprint technology which is carried out by applying a photo-curable liquid resin onto a substrate at room temperature, pressing a transparent mold to the liquid resin, and exposing the liquid resin on the substrate to light to cure it. Particularly, in the photo-nanoimprint technology, it is possible to form a pattern at room temperature, and therefore there is little strain caused by heating based on the difference between coefficient of thermal expansions of the substrate and the mold, whereby an accurate pattern can be formed. Hence, the photo-nanoimprint technology receives much attention as technology instead of lithography for semiconductor or the like.

Though a pattern molding can be cheaply carried out by the nanoimprint technology, a resin is apt to stick to an original mold (metallic mold) as a mother stamper. If the resin sticks to the original mold, it is extremely difficult to repair the resin-sticking mold. The mold is highly expensive, and therefore the nanoimprint technology necessarily is not cheap from the viewpoint of the whole production cost.

Patent Document 1 (JP2007-165812 A) discloses an imprint method comprising two steps. In more detail, in a first step, a foil of plastic polymer such as thermoplastic polymer is placed on a template having a surface (the above mother stamper) on which a fine concave-convex pattern of micrometer or nanometer order is formed, such that the surface of the foil is in contact with the surface of the template, and a pattern that the pattern of the template is inverted is formed on the surface of the polymer foil by imprint processing. And, in a second step, the pattern on the surface of the resultant polymer stamper (intermediate stamper) is processed by the same imprint processing as above to form a second inversed pattern (the same as the template) on another plastic polymer foil.

### Prior Patent Documents

### Patent Documents

Patent Document 1: JP2007-165 812 A

### Brief Summary of the Invention

### Problem to be solved by the invention

In the imprint method of described in Patent Document 1, critical damage is not generated on the mother stamper (template) because the molding is carried out by using the intermediate stamper. For preparing the intermediate stamper, thermoplastic polymer is used, which enables various polymers to be widely used. However, the method has the disadvantages that a large amount of energy is required for heating and cooling in the molding and that a long time period of one or more minute is necessary for the molding. In more detail, the long time period for the processing renders the reduction of tact time (time period for the processing) difficult, if the processing is carried out continuously..

Further, Patent Document 1 describes an example that photo-curable resin is combined with the thermoplastic polymer in the preparation of the intermediate stamper. However, the photo-curable resin is liquid, and therefore suffers from poor workability, large cure shrinkage and increased variation of thickness. Thus it is impossible to enhance the productivity including the reduction of tact time.

Thus, an object of the present invention is to provide a method for forming concave-convex pattern corresponding to a nanoimprint method which is advantageously utilized in the preparation of electronic devices, optical parts and recording media, and which enables the preparation of the products having the fine pattern as mentioned above in cheapness and high speed.

Further, an object of the present invention is to provide an apparatus for preparing concave-convex pattern which is advantageously used in the method for forming concave-convex pattern.

### Means for Solving Problem

The above-mentioned object can be attained by a method for forming a concave-convex pattern comprising of the steps (1) to (4):
a step (1) of placing a stamper having a fine concave-convex pattern surface thereon on a photo-curable transfer layer of a photo-curable transfer sheet, the photo-curable transfer sheet comprising a transparent film and the photo-curable transfer layer thereon, such that the concave-convex pattern surface of the stamper is in contact with a surface of the photo-curable transfer layer, and depressing the stamper and the photo-curable transfer sheet to form a laminate in which one side of the photo-curable transfer layer adheres closely to the concave-convex pattern surface;
a step (2) of exposing the photo-curable transfer layer of the laminate having the stamper to ultraviolet rays to cure the photo-curable transfer layer, and removing the stamper from the laminate to form an inverted pattern of the fine concave-convex pattern on a surface of the photo-curable transfer layer, the photo-curable transfer sheet having the inverted fine concave-convex pattern surface being referred to as an intermediate stamper;
a step (3) of placing the intermediate stamper on a photo-curable transfer layer of another photo-curable transfer sheet, the another photo-curable transfer sheet comprising a transparent film and the photo-curable transfer layer thereon, such that the inverted concave-convex pattern surface of the intermediate stamper is in contact with a surface of the photo-curable transfer layer of the another photo-curable transfer sheet and depressing the intermediate stamper and the another photo-curable transfer sheet to form a laminate in which one side of the another photo-curable transfer layer adheres closely to the inverted concave-convex pattern surface; and
a step (4) of exposing the photo-curable transfer layer of the laminate having the intermediate stamper to ultraviolet rays to cure the photo-curable transfer layer, and removing the intermediate stamper from the laminate to form a fine concave-convex pattern on a surface of the photo-curable transfer layer, the fine concave-convex pattern being the same as that of the stamper, whereby the photo-curable transfer sheet having the fine concave-convex pattern surface is obtained.

The preferred embodiments of the photo-curable transfer sheet according to the present invention are as follows:

1) The placing and depressing procedures in the step (1) and the exposing procedure to ultraviolet rays in the step (2) are carried out at the same time, and/or the placing and depressing procedures in the step (3) and the exposing procedure to ultraviolet rays in the step (4) are carried out at the same time. Thereby the tact time is reduced.

2) The photo-curable transfer layers used in the steps (1) and (3) comprise a photo-curable composition deformable by application of pressure.

3) The photo-curable transfer layer used in at least the step (1) contains a lubricant. Thus, both the photo-curable transfer layers used in the steps (1) and (3) can contain a lubricant, whereby the mold release characteristics can be enhanced. The lubricant preferably is a phosphorus atom-containing compound or modified polysiloxane, especially (meth)acryloyl group-containing polysiloxane. The photo-curable composition preferably contains the lubricant in an amount of 0.01 to 20% by weight.

In the method for forming a fine concave-convex pattern such as a nanoimprint method, the reduction of the tact time is important in order to enhance productivity and decrease cost. In case the peel property (mold release characteristics) of the stamper from the sheet is not good, it is difficult to reduce the tact time. Since the sheet having a cured transfer layer peeled from the stamper is so flexible or limp and therefore does not have sufficient film self-supporting property, it is difficult to acquire sufficient handling properties such as mobility and winding property. Hence, the use of the lubricant greatly improves the handling properties.

4) The transparent film is a polymer film having an adhesion layer thereon. The adhesion layer generally comprises at least one resin selected from polyester resin, polyurethane resin and acrylic resin. The adhesion layer shows excellent adhesion (properties) to both the transfer layer and the polymer film. In the photo-curable transfer sheet, an adhesion film comprising a transparent film and adhesion layer thereon is provided on one surface of the photo-curable transfer layer such that the adhesion layer is in contact with the transfer layer.

5) The adhesion layer has a thickness of 0.01 to 0.3µm.

6) The polymer film is a polyester film (especially PET film). Thereby it is possible to give an appropriate film self-supporting properties.

7) The polymer film has a thickness of 1 to 500µm.

8) The photo-curable composition comprises a polymer and a reactive diluent having a photopolymerizable functional group.

9) The phosphorus atom-containing compound is a phosphoric acid ester compound.

10) The phosphorus atom-containing compound is a phosphoric acid ester compound represented by the following general formula (I):

[ka 1]

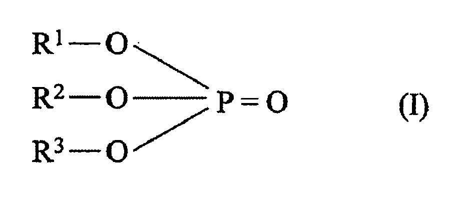

in which R¹, R² and R³ independently with each other represent a hydrogen atom, an alkyl group, an aryl group, an alkylaryl group, an arylalkyl group, an alkylpolyoxyalkylene group, or an arylpolyoxyalkylene group, each of these groups may have a substituent group, and at least one of R¹, R² and R³ represent the groups other than a hydrogen atom.

11) The phosphorus atom-containing compound is a phosphoric acid alkylpolyoxyalkylene compound represented by the following general formula (II):

[ka 2]

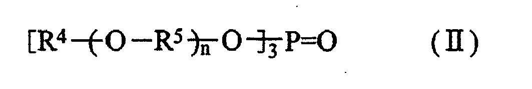

in which R⁴ represents an alkyl group, an aryl group, an alkylaryl group or an arylalkyl group, each of these groups may have a substituent group, R⁵ represents -CH₂CH₂- or -CH(CH₃) CH₂-, and n is 1 to 20.

12) The glass transition temperature of the polymer is not less than 80°C.

13) The glass transition temperature of the photo-curable transfer layer after subjecting to ultraviolet exposure in irradiation energy of 300 to 300mJ/cm² is not less than 65°C. The ultraviolet exposure for a short time period enables the prevention of occurrence of sagging in the form of concave-convex, the sagging being apt to occur due to residual stress in the transferring procedure, whereby the transferred concave-convex form (pattern) can be maintained.

14) The glass transition temperature of the photo-curable composition (generally photo-curable transfer layer) is less than 20°C. Thereby the excellent transfer property can be obtained.

15) The photo-curable composition further contains polyisocyanate, preferably diisocyanate. Post-crosslinking (after-crosslinking) before light curing can be carried out to enhance shape-maintaining property of a sheet before transferring.

16) The polymer having glass transition temperature of not less than 80°C is acrylic resin.

17) The acrylic resin has at least 50% by weight of recurring unit of methyl methacrylate. An appropriate combination of the acrylic resin with the reactive diluent brings about both excellent transferring property and curing property.

18) The acrylic resin has a photopolymerizable functional group.

19) The acrylic resin has a hydroxyl group.

20) The acrylic resin has at least 50% by weight of recurring unit of methyl methacrylate. An appropriate combination of the acrylic resin with the reactive diluent brings about both excellent transferring property and curing property.

21) The polymer having a glass transition temperature of not less than 80°C has number average molecular weight of not less than 100,000 and/or weight average molecular weight of not less than 100,000. Particularly, number average molecular weight of 100,000 to 300,000 and weight average molecular weight of 100,000 to 300,000 are preferred. By optimizing this molecular weight, the composition of acrylic resin and the ratio of reactive diluent as described later, specifically excellent transferring property and curing property can be obtained. The average molecular weight is determined according to GPC (Gel Permeation Chromatography) using polystyrene standard.

22) The photo-curable composition contains 0.1 to 10% by weight of a photopolymerization initiator.

23) The photo-curable transfer layer has a thickness of 1 to 300µm.

24) At lease the photo-curable transfer sheet used in the step (1) is in the form of continuous length.

The present invention is provided by an apparatus for preparing a concave-convex pattern comprising:
a delivery means for delivering a continuous photo-curable transfer sheet comprising a continuous transparent film and a photo-curable transfer layer thereon;
a first depression means for placing a stamper having a fine concave-convex pattern surface thereon on the photo-curable transfer layer of the continuous photo-curable transfer sheet, such that the concave-convex pattern surface of the stamper is in contact with a surface of the photo-curable transfer layer, and depressing the stamper and the continuous photo-curable transfer sheet;
a first ultraviolet exposure means for exposing the photo-curable transfer layer to ultraviolet rays at the same time as the depressing to form an inverted fine concave-convex pattern on a surface of the photo-curable transfer layer, the continuous photo-curable transfer sheet having the inverted fine concave-convex pattern surface being referred to as an intermediate stamper;
a second depression means for placing the intermediate stamper on a photo-curable transfer layer of another photo-curable transfer sheet, such that the inverted concave-convex pattern surface of the intermediate stamper is in contact with a surface of the photo-curable transfer layer of the continuous another photo-curable transfer sheet and depressing the intermediate stamper and the another photo-curable transfer sheet; and
a second ultraviolet exposure means for exposing the photo-curable transfer layer to ultraviolet rays at the same time as the depressing.

Also, the preferred embodiments of the method for forming a concave-convex pattern can be applied to the above-mentioned apparatus.

### Effect of the invention

In the method for forming a fine concave-convex pattern of the present invention which is according to a nanoimprint method and which uses the photo-curable transfer sheet, a final fine concave-convex pattern is prepared by using an intermediate stamper which is prepared from a mother stamper and the photo-curable transfer sheet, and hence the mother stamper does not suffer from damage. Further the photo-curable transfer sheet is used, and therefore the formation of fine concave-convex pattern can be carried out in excellent workability and high productivity. Furthermore, both the preparation of the intermediate stamper (the steps 1 and 2) and the formation of the final fine concave-convex pattern (the steps 3 and 4) are carried out by light (UV) curing, and therefore the tact time (time period for processing) can be reduced to bring about the further enhancement of productivity and the reduction of cost.

Particularly, in case the transfer layer of the photo-curable transfer sheet used in the preparation of the intermediate stamper contains a lubricant, it is easy to peel the final product from the intermediate stamper.

Thus, the use of the method for forming concave-convex pattern of the present invention advantageously brings about the preparation of electronic display rib, electronic devices (lithography, transistor), optical elements (microlens array, waveguide, optical filter, photonic(s) crystal), bio-related materials (DNA tip, microreactor) and recording media (patterned media, DVD).

### Brief Description of the Drawings

[Fig. 1]

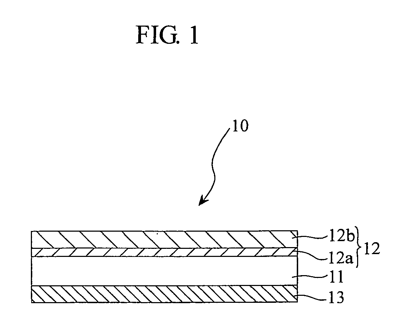

   Fig. 1 is a section view showing a representative example of an embodiment of the photo-curable transfer sheet of the present invention.
[Fig. 2]

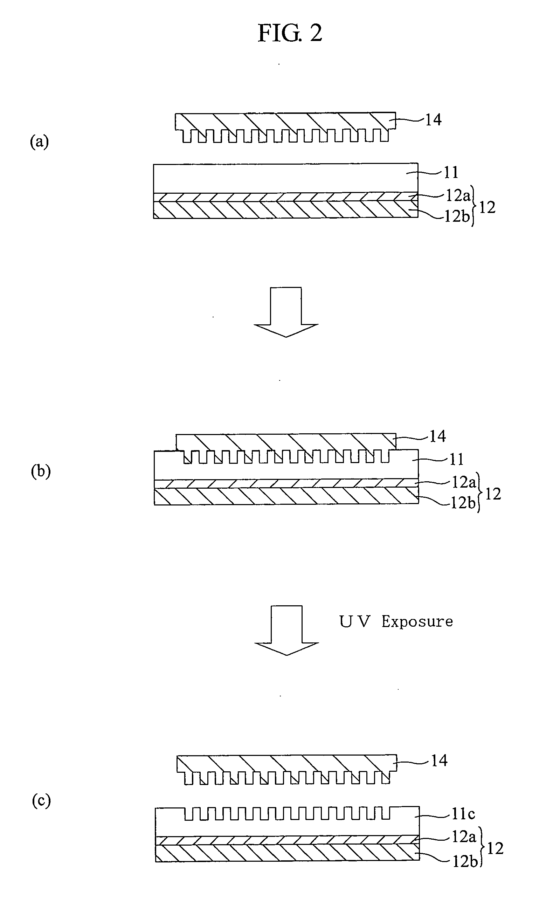

   Fig. 2 is a schematic section view showing an example of a method for forming fine concave-convex pattern of the present invention.
[Fig. 3]

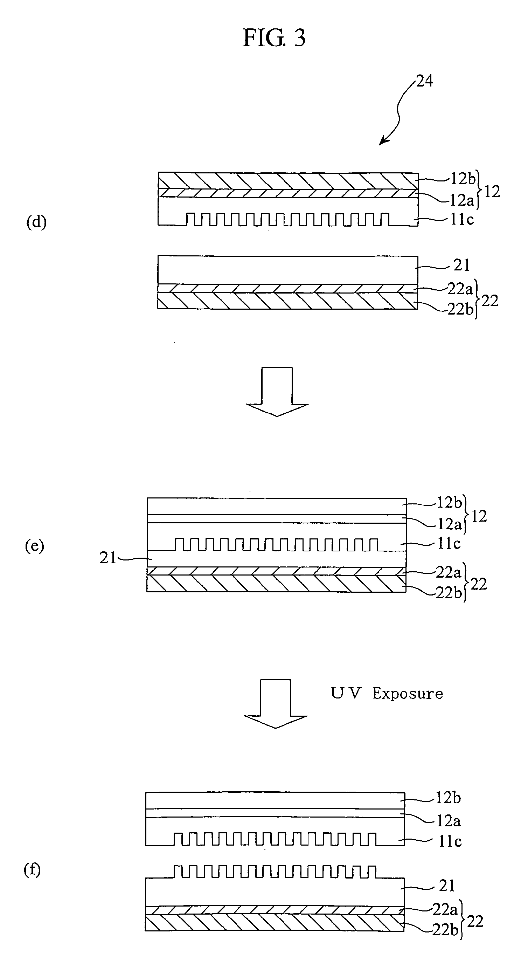

   Fig. 3 is a schematic section view showing an example of a method for forming fine concave-convex pattern of the present invention (continuation of Fig. 2).
[Fig. 4]

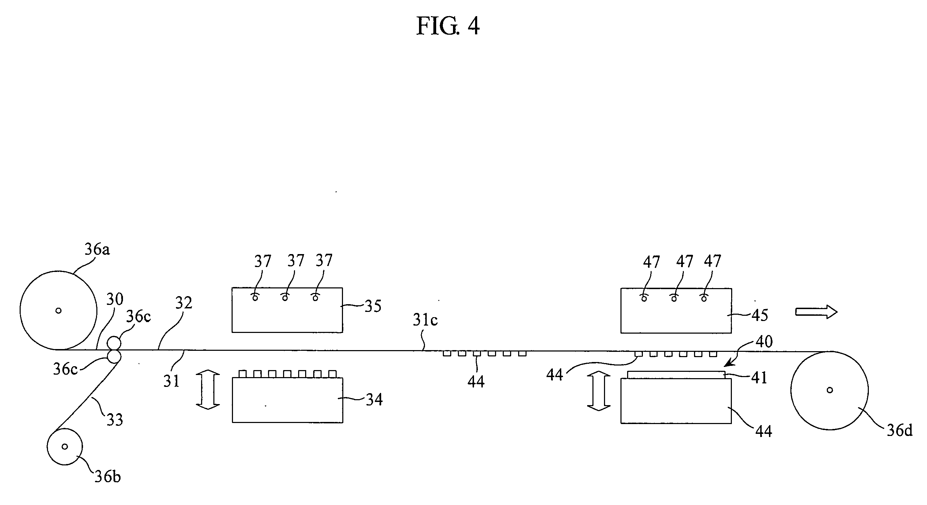

   Fig. 4 is a schematic section view showing an example of a continuous method (or an apparatus) for forming fine concave-convex pattern of the present invention.
[Fig. 5]

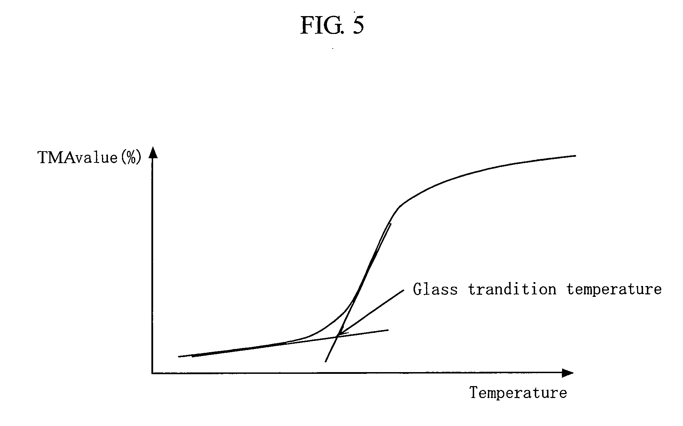

   Fig. 5 is a graph used in the determination of glass transition temperature (Tg).

### Mode for Carrying out the Invention

Embodiments of the invention are explained in detail by referring to drawings.

Fig. 1 is a section view showing a representative example of an embodiment of the photo-curable transfer sheet 10 used in the method for forming fine concave-convex pattern of the present invention. A photo-curable transfer layer 11 has an adhesion film 13 consisting of a polymer film 12b having an adhesion layer 12a thereon, the adhesion film 13 being provided on one side of the layer 11, and further has a release sheet 13 on the other side of the layer 11. The adhesion film 12 strongly adheres to the photo-curable transfer layer 11 by the adhesion layer 12a. The adhesion layer 12a shows excellent adhesion properties to the photo-curable transfer layer 11, the cured photo-curable transfer layer 11 and the polymer film 12b. The polymer film 12b gives film self-supporting characteristics to the photo-curable transfer sheet 10 and the cured photo-curable transfer sheet 10. The release sheet 13 is provided for protection and hence is generally removed when the sheet is used. The release sheet 13 generally consists of a plastic sheet and a release layer provided thereon, and the release layer is in contact with a surface of the photo-curable transfer layer 11.

The photo-curable transfer layer 11 is configured to be easily deformable by application of pressure such that fine concave-convex pattern of a stamper (generally mother stamper) of an intermediate stamper can be precisely transferred to the layer by depressing the stamper and the layer, and at the same time, to have excellent peeling properties (mold release characteristics) from the stamper after curing. In more detail, the photo-curable transfer sheet 11 comprises a photo-curable composition (generally comprising a polymer and a reactive diluent having a photopolymerizable functional group) and preferably contains further a lubricant. Particularly, a photo-curable transfer layer used in the preparation of the intermediate stamper preferably contains a lubricant. Thereby the cured transfer layer comes to have the surface which is apt to peel from the stamper, and hence a part of the transfer layer scarcely attaches to the stamper. Further, when a final product having the same concave-convex pattern as the mother stamper is formed by using the intermediate stamper, a photo-curable transfer sheet corresponding to the final product can be also easily peeled from the intermediate stamper. In case the photo-curable transfer sheet corresponding to the final product also contains the lubricant, the peeling properties from the intermediate stamper are further enhanced.

In the invention, the photo curable composition comprises an acrylic resin having glass transition temperature of not less than 80°C, whereby the fine concave-convex pattern of the mother stamper or the intermediate stamper can be easily transferred and the curing can be carried out in high speed. Further the cured shape is maintained without variation of the shape for a long time period because of the high Tg. The polymer having glass transition temperature (Tg) of not less than 80°C preferably has a photopolymerizable functional group because it can be reacted with the reactive diluent to enhance the curing rate. The polymer preferably has hydroxyl group because the transfer layer can be a little cured by use of diisocyanate whereby exudation of the integrant of the layer and variation of the thickness are greatly repressed. The use of the diisocyanate is effective to some extent even if the polymer has no hydroxy group.

The method for forming a fine concave-convex pattern of the invention carried out by using the above photo-curable transfer sheet 10 is explained with reference to the drawings. Generally, a nanoimprint method can be also carried out in the same manner as the method for forming a fine concave-convex pattern.

The schematic section views illustrating the representative embodiment of the method for forming a fine concave-convex pattern of the invention are shown in Figs. 2 and 3
First, the release sheet 13 is removed from the photo-curable transfer sheet 10, and the photo-curable transfer layer 11 is exposed. The photo-curable transfer layer 11 is bonded and fixed onto the adhesive layer 12a of the adhesion film 12 comprising the polymer film 12b and the adhesive layer 12a thereon. A mother stamper 14 is arranged on the photo-curable transfer layer 11 such that the fine concave-convex pattern of the mother stamper 14 faces the surface of the photo-curable transfer layer 11 (stage (a)). Subsequently, the mother stamper 14 is depressed on the photo-curable transfer layer 11 (stage (b)). The stages (a) and (b) constitutes the step (1). If necessary, the photo-curable transfer layer 11 is heated to enable the depression. In case the depression can be carried out at room temperature, the heating is unnecessary. Under this condition, the photo-curable transfer layer 11 is exposed to light (UV) to cure. It is preferred that the exposure to light is carried out with the depression because of reduction of tact time. Then, the stamper 14 is removed (peeled) from the photo-curable transfer layer 11c (stage (c)). The stage (c) constitutes the step (2). In this way, the fine concave-convex pattern is formed on the photo-curable transfer layer 11 to give an intermediate stamper having the inverted fine concave-convex pattern that the fine concave-convex pattern of the mother stamper is inverted.

A release sheet is removed from another photo-curable transfer sheet, and the photo-curable transfer layer 21 exposed is bonded and fixed onto the adhesive layer 22a of the adhesion film 22 comprising the polymer film 22b and the adhesive layer 22a thereon. Thus a photo-curable transfer sheet is prepared. The intermediate stamper 24 prepared above which consists of the adhesion film 12 and the photo-curable transfer layer 11c having the inverted fine concave-convex pattern formed thereon is arranged on the photo-curable transfer layer 21 such that the inverted fine concave-convex pattern faces the surface of the photo-curable transfer layer 21 (stage (d)). Subsequently, the intermediate stamper 24 is depressed on the photo-curable transfer layer 21 (stage (e)). The stages (d) and (e) constitutes the step (3). If necessary, the photo-curable transfer layer 21 is heated to enable the depression. In case the depression can be carried out at room temperature, the heating is unnecessary. Under this condition, the photo-curable transfer layer 21 is exposed to light (UV) to cure. It is preferred that the exposure to light is carried out with the depression because of reduction of tact time. Then, the intermediate stamper 24 removed (peeled) from the photo-curable transfer layer 21 (stage (f)). The stage (f) constitutes the step (4). In this way, the fine concave-convex pattern is formed on the photo-curable transfer layer 21 to give a sheet having the fine concave-convex pattern that is the same as the concave-convex pattern of the mother stamper. Generally, the steps (1) to (4) are repeated to give photo-curable transfer layers having fine concave-convex pattern. However, a number of photo-curable transfer layers can be prepared by using the intermediate stamper. In more detail, after the steps (1) to (2) are carried out, the steps (3) to (4) can be repeated.

The photo-curable transfer layer 11 placed on the fine concave-convex pattern surface of the mother stamper 14 preferably contains a lubricant, and the adhesion film 12 giving self-supporting properties is preferably bonded to the back side of the photo-curable transfer layer 11. Thereby the mother stamper 14 can be easily removed from the cured photo-curable transfer layer 11, and a part of the cured layer is not transferred to the mother stamper. Another photo-curable transfer layer 21 also preferably contains a lubricant, and the adhesion film 22 giving self-supporting properties is preferably bonded to the back side of the photo-curable transfer layer 21. Further, it is preferred that the photo-curable transfer sheet of the invention is used after a lapse of at least 30 minutes after the photo-curable transfer layer is formed on the adhesion layer, whereby the excellent adhesion between the photo-curable transfer layer and the adhesion layer can be ensured.

A schematic section view illustrating a representative embodiment of a continuous method for forming fine concave-convex pattern of the present invention is shown in Fig. 4. First, a continuous photo-curable transfer sheet 30 having an exposed photo-curable transfer layer 31 which is bonded and fixed onto an adhesion film 32 (comprising a polymer film and an adhesive layer) is delivered from a lead-on roll 36a, and a release sheet 33 is wound around a wind-up roll 36b through a guide roll 36c to be removed. The continuous photo-curable transfer sheet 30 generally has a width of 50 to 500mm and a length of 100 to 2000m, and the transportation velocity generally is 0.2 to 2m/min. The photo-curable transfer sheet 30 is transported in the direction of arrow, and when it comes at a UV- transmission type pressure bonding part 35 provided with a mother stamper part 34 movable up and down and a UV lamp 37 (i.e., between 35 and 37), it comes to a stop. The stop time generally is one to five seconds. At the same time of the stop, the mother stamper part 34 moves upward and pushes up the photo-curable transfer layer 31 of the photo-curable transfer sheet 30, whereas the adhesion film 32 on the back side of the pushed photo-curable transfer layer 31 is supported by the UV- transmission type pressure bonding part 35. Hence the photo-curable transfer layer 31 is compressed by the mother stamper 34. After or on the compression, the photo-curable transfer layer 31 is exposed to light of the UV lamp 37 to be cured. Thereafter, the mother stamper part 34 moves downward, and at the same time the cured photo-curable transfer layer 31 c having the adhesion film 32 is put in transportation. The photo-curable transfer layer 31 provided with the adhesion film 32 has a fine concave-convex pattern formed by inversion of the fine concave-convex pattern of the mother stamper part 34, and is used as an intermediate stamper 44 in the following step.

Continuously, the intermediate stamper 44 is transported in the direction of arrow, and when it comes at a UV- transmission type pressure bonding part 45 provided with a mother stamper part 44 movable up and down and a UV lamp 47 (i.e., between 45 and 47), it comes to a stop. The stop time generally is one to five seconds. At the same time of the stop, a photo-curable transfer sheet 40 having another photo-curable transfer layer 41 placed on a sheet setting platform 44 moves upward, whereas an adhesion film 42 on the back side of the intermediate stamper 44 is supported by the UV- transmission type pressure bonding part 45. Hence the photo-curable transfer layer 41 is compressed by the intermediate stamper 44. After or on the compression, the photo-curable transfer layer 41 is exposed to light of the UV lamp 47 to be cured. Thereafter, the sheet setting platform 44 moves downward, and at the same time the cured photo-curable transfer layer 41 having the adhesion film 42 is demolded. Thus, a fine concave-convex pattern is formed on the photo-curable transfer layer 41, and hence a sheet having the fine concave-convex pattern which is the same as the mother stamper is obtained. The intermediate stamper 44 is wound around a wind-up roll 36d.

In Fig. 4, the photo-curable transfer sheet 40 is not continuous and therefore is fed sheet by sheet. However, instead the sheet, a continuous photo-curable transfer sheet may be fed by using a roll.

When the photo-curable transfer sheet is compressed between the stamper or the sheet setting platform and the UV- transmission type pressure bonding part, the photo-curable transfer sheet is generally stopped briefly as above. However, the stamper or the sheet setting platform and the UV- transmission type pressure bonding part may be moved together with the photo-curable transfer sheet.

The transparent film used in the invention generally is an adhesion film 12, 22, which is composed of a polymer film 12b, 22b and an adhesion layer 12a, 22a thereon.

The polymer film 12b, 22b of the invention generally is a polyester film. The polyester is generally linear saturated polyester derived from aromatic dibasic acid or ester-forming derivative thereof and diol or ester-forming derivative thereof.

Examples the polyester include polyethylene terephthalate (PET), polyethylene isophthalate, polybutylene terephthalate, poly(1,4-cyclohexylene terephthalate), and polyethylene-2,6-naphthalate. Copolymers of these monomers or a blend of the polyester with other resin as an accessory component (in amount of less than 50 mol%) can be also used. Of these polyesters, polyethylene terephthalate (PET) and polyethylene-2,6-naphthalate are preferred in view of balance between mechanical properties and optical properties. Particularly, polyethylene-2,6-naphthalate has increased mechanical strength, reduced heat shrinkage and reduced amount of oligomer generated on heating, and therefore is excellent compared with polyethylene terephthalate from these viewpoints.

Thought the polyester may be homopolymer, or copolymer copolymerized with a third component, the homopolymer is preferred. In case the basic polyester is polyethylene terephthalate, isophthalic acid copolymerized polyethylene terephthalate is most suitable. The isophthalic acid copolymerized polyethylene terephthalate preferably contains 5 mol% or less of isophthalic acid. The polyester may contain copolymerizable component other than isophthalic acid or copolymerizable alcohol component in an amount of not more than 3 mol% based on the total of acid component and alcohol component so long as the characteristics of the polyester is not damaged. Examples of the copolymerizable acid component include aromatic dicarboxylic acids such as phthalic acid and 2,6-naphthalene dicarboxylic acid; aliphatic dicarboxylic acids such as adipic acid, azelaic acid, sebacic acid, 1,10-decan dicarboxylic acid. Examples of the copolymerizable alcohol component include aliphatic diols such as 1,4-butane diol, 1,6-hexane diol, neopentyl glycol, and cycloaliphatic diols such as 1,4-cyclohexane dinethanol. These can be used singly or in combination of two or more kinds.

In case the basic polyester is polyethylene-2,6-naphthalate, naphthalene dicarboxylic acid is used as the main dicarboxylic acid component and ethylene glycol is used as the main glycol component. Examples of the naphthalene dicarboxylic acid include 2,6-naphthalene dicarboxylic acid, 2,7-naphthalene dicarboxylic acid, 1,5-naphthalene dicarboxylic acid, and 2,6-naphthalene dicarboxylic acid is preferred. The "main" of the main component means that the main component is included in the polymer in the amount of at least 90 mol%, preferably at least 95 mol% based on the total recurring units of the polymer.

In case the polyethylene-2,6-naphthalene dicarboxylate is a copolymer, any compounds having ester-forming-functional groups can be used as copolymerizable components constituting the copolymer. As the compounds, dicarboxylic acids such as oxalic acid, adipic acid, phthalic acid, sebacic acid, dodecane dicarboxylic acid, isophthalic acid, terephthalic acid, 1,4-cyclohexane dicarboxylic acid, 4,4'-diphenyl dicarboxylic acid, phenylindane dicarboxylic acid, 2,7-naphtalene dicarboxylic acid, tetralin dicarboxylic acid, decalin dicarboxylic acid, diphenyl ether dicarboxylic acid; oxycarboxylic acid such as p-oxybenzoic acid, p-oxyethoxybenzoic acid; and dihydric alcohols such as propylene glycol, trimethylene glycol, tetramethylene glycol, hexamethylene glycol, cyclohexane methylene glycol, neopentyl glycol, ethylene oxide adduct of bisphenol sulfone, ethylene oxide adduct of bisphenol A, diethylene glycol, polyethylene oxide glycol can be preferably used.

These compounds can be used singly or in combination of two or more kinds. Of these compounds, preferred acid components are isophthalic acid, terephthalic acid, 4,4'-diphenyl dicarboxylic acid, 2,7-naphtalene dicarboxylic acid, p-oxybenzoic acid, and the preferred glycols are trimethylene glycol, hexamethylene glycol, neopentyl glycol, ethylene oxide adduct of bisphenol sulfone.

Further, the polyethylene-2,6-naphthalene dicarboxylate may be, for example, one that a part or all of the terminal hydroxy groups and/or carboxyl groups are blocked by a mono-functional compound such as benzoic acid or methoxypolyalkylene glycol, or one that is copolymerized with a slight amount of tri or more functional ester-forming compound such as glycerol or pentaerythritol as long as a substantially linear polymer is formed.

The polyester of the invention can be obtained by conventional processes, for example, a process for directly preparing polyester having low polymerization degree; or a process for preparing polyester by reacting lower alkyl ester of dicarboxylic acid with glycol by using a conventional transesterification catalyst such compounds containing sodium, potassium, magnesium, calcium, zinc, strontium, titanium, zirconium, manganese or cobalt in one kind or two or more kinds and polymerizing the mixture in the presence of a polymerization catalyst. As the polymerization catalyst, antimony compounds such as antimony trioxide and antimony pentaoxide; germanium compounds such as germanium dioxide; and titanium compounds such as tetraethyl titanate, tetrapropyl titanate, tetraphenyl titanate, and partial hydrolysate thereof, and ammonium titanyl oxalate, sodium titanyl oxalate and titanium triacetyl acetonate; can be used.

In case the polymerization is carried out through transesterification, a phosphorus compound such as trimethyl phosphate, triethyl phosphate, tri-n-butyl phosphate or orthophosphoric acid is added in order to deactivate the transesterification catalyst before the polymerization. The polyethylene-2,6-naphthalene dicarboxylate preferably contains the compound in the amount of 20 to 100ppm in terms of phosphorus atom.

The polyester may be cut to tip after melt polymerization and the tip may be further subjected to solid-state polymerization in a stream of inert gas such as nitrogen.

In the invention, the polyester preferably has 90 mol% or more, further preferably 95 mol% or more, especially 97 mol% or more of ethylene-terephthalate unit or ethylene-2,6-carboxylate unit. The intrinsic viscosity of the polyester preferably is 0.40dl/g or more, further preferably 0.40 to 0.90dl/g. The use of the polyester having less than 0.40dl/g occasionally brings about a lot of cuttings in a processing, whereas the use of the polyester having more than 0.90dl/g renders melt extrusion difficult due to high melt viscosity to increase the polymerization time period which increases cost. The polyester film of the invention is required to substantially contain no particle. If the polyester contains a particle, it suffers from reduction of transparency or rough surface.

The polyester film of the invention preferably has rate of dimension change of -2 to +2%, the rate being determined at 200°C under load of 140g/mm² in a longitudinal direction. In case the rate is less than -2% or more than +2%, a laminate obtained by superposing a functional layer on the polyester film is apt to suffer from cracking or wrinkle, which occurs on or after the superposing process, and the occurrence of the wrinkle occasionally destroys the laminate whereby its function cannot be sufficiently obtained. The rate of dimension change determined at 200°C under load of 140g/mm² is more preferably -1.5 to +1.5%, further preferably -1.0 to +1.0%, especially preferably -0.5 to +0.5%. The polyester of the invention having high transparency and adhesion property has preferably haze of 1.5% or less, further preferably 1.0% or less, especially preferably 0.5% or less.

The three-dimensional center line average (surface roughness) of both sides of the polyester film is preferably 0.0001 to 0.02µm, further preferably 0.0001 to 0.015µm, especially preferably 0.0001 to 0.010µm. Particularly, in case the three-dimensional center line average of at least one side of the polyester film is 0.0001 to 0.005µm, the functional layer obtained by laminating it on the polyester film has extremely smooth. It is most preferable that the three-dimensional center line average of at least one side of the polyester film is 0.0005 to 0.004µm.

The adhesive polyester film of the invention has preferably a thickness of 1 to 500µm, more preferably 3 to 400µm, further preferably 6 to 300µm, especially preferably 12 to 250µm.

The preferable process for the preparation of the adhesive polyester film of the invention is explained. A glass transition temperature is abbreviated to Tg. The polyester film of the invention can be prepared by extruding melt polyester in the form of film, cooling and solidifying the extruded polyester film by means of a casting drum to form an unstretched film, and stretching the unstretched film at a temperature of Tg to (Tg+60)°C in the longitudinal direction one or two or more times such that the total stretching ratio becomes 3 to 6 times, and then stretching the stretched film at a temperature of Tg to (Tg+60) °C in the width direction such that the total stretching ratio becomes 3 to 5 times, and if desired subjecting to heat treatment at 180 to 255°C for 1 to 60 seconds.

An adhesion layer is preferably provided on at least one side of the polymer film such as polyester film according to the invention, the adhesion layer consisting of polyester resin, polyurethane resin, acrylic resin or the combination of two or more kinds thereof. The combination (A) of polyester resin and acrylic resin (preferably one having functional group such as an oxazoline group), and the combination (B) of polyester resin and polyurethane resin (preferably water soluble or water dispersible polyurethane) are preferred.

An adhesion layer consisting of polyester resin and acrylic resin having an oxazoline group and polyalkylene oxide chain corresponding to the combination (A) is described as follows:

The polyester resin of the combination (A) preferably is polyester soluble or dispersible in water (which may contain a little organic solvent).

The polyester is preferably prepared from polybasic acid or ester-forming derivative thereof and polyol or ester-forming derivative thereof, which are mentioned below.

Examples of the polybasic acid component of the polyester include terephthalic acid, isophthalic acid, phthalic acid, phthalic anhydride, adipic acid, sebacic acid, trimellitic acid, pyromellitic acid, dimer acid, and 5-sodiumsulfo isophthalic acid. Copolymerized polyester derived from materials including two or more kinds of the acid components is preferred The polyester may contain a little unsaturated polybasic acid components such as maleic acid, itaconic acid or hydroxy carboxylic acid components such as p-hydroxy benzoic acid.

Examples of the polyol component of the polyester include ethylene glycol, 1,4-butane diol, diethylene glycol, dipropylene glycol, 1,6-hexamethylene glycol, 1,4-cyclohexane dimethanol, xylylene glycol, dimethylol propane, poly(ethylene oxide) glycol, poly(tetramethylene oxide) glycol, and monomer thereof.

The acrylic resin of the combination (A) has preferably an oxazoline group and polyalkylene oxide chain. Particularly, preferred is acrylic resin soluble or dispersible in water which may contain a little organic solvent. The acrylic resin having an oxazoline group and polyalkylene oxide chain generally includes the following monomers as the components.

Examples of the monomers having an oxazoline group include 2-vinyl-2-oxazoline, 2-vinyl-4-methyl-2-oxazoline, 2-vinyl-5-methyl-2-oxazoline, 2-isopropenyl-2-oxazoline, 2-isopropenyl-4-methyl-2-oxazoline and 2-isopropenyl-5-methyl-2-oxazoline. The monomer can be used singly or in the combination of two or more kinds. Of these monomers, 2-isopropenyl-2-oxazoline is preferred because it is easily available industrially. The use of the acrylic resin having an oxazoline group brings about enhancement of cohesion force of the coated layer to increase the adhesion to a transfer layer. Further, examples of the monomers having polyalkylene oxide chain include acrylate or methacrylate obtained by adding polyalkylene oxide to the ester residue of the acrylate or methacrylate. Examples of the polyalkylene oxide chain include polymethylene oxide, polyethylene oxide, polypropylene oxide, and polybuylene oxide. The number of the recurring unit of polyalkylene oxide chain preferably is 3 to 100. The acrylic resin having polyalkylene oxide chain is improved in compatibility with polyester resin compared with acrylic resin having no polyalkylene oxide chain, whereby the adhesion layer is enhanced in transparency. The acrylic resins having the number of the recurring unit of polyalkylene oxide chain of less than 3 is reduced in compatibility with polyester resin to reduce transparency of the adhesion layer, whereas the acrylic resins having the number of the recurring unit of more than 100 renders resistance to moist heat of the adhesion layer insufficient to reduce adhesion property to a transfer layer under high humidity and high temperature.

Examples of monomers as the other copolymerizable components of the acrylic resin include alkyl acrylate and methacrylate (examples of alkyl including methyl group, ethyl group, n-propyl group, isopropyl group, n-butyl group, isobutyl group, t-butyl group, 2-ethylhexyl group, cyclohexyl group); hydroxy-containing monomers such as 2-hydroxyethyl acrylate, 2-hydroxyethyl methacrylate, 2-hydroxypropyl acrylate, 2-hydroxypropyl methacrylate; epoxy-group-containing monomers such as glycidyl methacrylate, glycidyl methacrylate and allyl glycidyl ether; monomers having carboxyl group (e.g., acrylic acid, methacrylic acid, itaconic acid, maleic acid, fumaric acid crotonic acid, styrene sulfonic acid) and salts thereof (e.g., sodium salt, potassium salt, ammonium salt, tertiary amine); monomers having amide group such as acrylamide, methacrylamide N-alkyl acrylamide, N-alkyl methacrylamide, N,N-dialkyl acrylamide, N,N-dialkyl methacrylamide (examples of alkyl including methyl group, ethyl group, n-butyl group, isobutyl group), acryloyl morpholine, N-methylol acrylamide, N-methylol methacrylamide, N-phenyl acrylamide, N-phenyl methacrylamide; acid anhydride monomers such as maleic anhydride and itaconic anhydride; other monomers such as vinyl isocyanate, allyl isocyanate, styrene, α-methylstyrene, vinyl methyl ether, vinyl ethyl ether, vinyl trialkoxy silane, alkyl maleic acid monoester, alkyl fumaric acid monoester, alkyl itaconic acid monoester, acrylonitrile, methacrylonitrile, vinylidene chloride, ethylene, propylene, vinyl chloride, vinyl acetate, butadiene.

The content of the polyester for forming the adhesion layer in the adhesion layer is preferably 5 to 95% by weight, especially 50 to 90% by weight. The content of the acrylic resin having an oxazoline group and polyalkylene oxide chain for forming the adhesion layer in the adhesion layer is preferably 5 to 90% by weight, especially 10 to 50% by weight. In case the content of the polyester is more than 95% by weight or the content of the acrylic resin having an oxazoline group and polyalkylene oxide chain is less than 5% by weight, the resultant coated layer shows reduction of cohesion force to occasionally render adhesion property to a transfer layer insufficient. In contrast, in case the content of the acrylic resin having an oxazoline group and polyalkylene oxide chain is more than 90% by weight, the resultant adhesion layer shows reduced adhesion property to the polyester film to occasionally render adhesion property to a transfer layer insufficient.

The adhesion layer preferably contains 0.5 to 30% by weight, further preferably 1 to 10% by weight, of aliphatic wax. When the amount of the wax is less than 0.5% by weight, the surface of the film occasionally does not show lubricating property. In contrast, when the amount of the wax is more than 30% by weight, the resultant adhesion layer occasionally does not show adhesion property to the polymer film, or a hard coat or adhesive.

Examples of the aliphatic wax include plant derived waxes such as carnauba wax, candelilla wax, rice wax, Japan wax, jojoba oil, palm wax, rosin modified wax, ouricury wax, sugar (sugar cane) wax, esparto wax and bark wax; animal derived waxes such as beeswax, lanolin, spermaceti wax, insect wax (Ibotaro) and shellac wax; mineral derived waxes such as montan wax, ozocerite and ceresin wax; petroleum derived waxes such as paraffin wax, microcrystalline wax and petrolatum; and synthetic hydrocarbon waxes such as fischer-tropsch wax, polyethylene wax, oxidized polyethylene wax, polypropylene wax and oxidized polypropylene wax. Carnauba wax, paraffin wax and polyethylene wax are preferred because they have good adhesion property and lubrication property to a hard coat or adhesive. Particularly, the water dispersion of the wax is preferred in view of environmental problems and handling.

The adhesion layer preferably contains filler having mean particle size of 0.005 to 0.5µm in the amount of 0.1 to 20% by weight. When the coated layer contains the filler in the amount of less than 0.1% by weight, the film shows poor lubricating property to occasionally render winding of the film in the form of roll difficult. In contrast, when the coated layer contains the filler in the amount of more than 20% by weight, the coated layer shows reduced transparency to occasionally render the use for a display impossible.

Examples of the filler include inorganic fine particles such as calcium carbonate, magnesium carbonate, calcium oxide, zinc oxide, magnesium oxide, silicon oxide, sodium silicate, aluminum hydroxide, iron oxide, zirconium oxide, barium sulfate, titanium oxide, tin oxide, antimony trioxide, carbon black, molybdenum disulfide; organic fine particles such as acrylic crosslinked polymer, styrene crosslinked polymer, silicon resin, fluoro resin, benzoguanamine resin, phenol resin, nylon resin and polyethylene wax. Of these fillers, super fine particles having specific weight of not more than 3 are preferably selected in order to prevent the sedimentation in the water dispersion.

A coating liquid of the combination (A) for coating the adhesion layer is preferably used in the form of an aqueous solution, a water dispersion or an emulsion. For forming the coated layer, if necessary, it is possible to add other resins, an antistatic agent, a coloring agent, a surface-active agent and an ultraviolet ray absorber except the above-mentioned components. Particularly, the addition of a lubricant enables enhancement of lubricating property and blocking resistance.

The coating liquid can be applied onto the polyester film in an optional stage. However, it is preferred to carry out the application in the process of preparing the polyester film, and further preferred to carry out the application to the polyester film before the completion of orientational crystallization. The polyester film before the completion of orientational crystallization includes a unoriented film, a uniaxially-oriented film obtained by orienting a unoriented film in a longitudinal or crosswise direction, and a diaxially-oriented film obtained by orienting a unoriented film in longitudinal and crosswise directions (i.e., two directions) in low magnification ratio (therefore the diaxially-oriented film being further oriented in a longitudinal or crosswise direction to complete orientational crystallization). Particularly, it is preferred that the unoriented film or the uniaxially-oriented film is coated with the aqueous coating liquid as above, and directly subjected to orientation in longitudinal and/or crosswise directions and heat fixation.

In the application of the coating liquid onto the film, it is preferred to subject the surface of the film to physical treatments such as corona treatment, flame treatment and plasma treatment as preliminary treatment, or to combining the coating liquid with a surface active agent which is chemically inactive to the liquid.

Conventional coating methods can be used as the coating method. Examples of the coating method include roll coating method, gravure-roll method, roll brush method, spray coating method, air knife coating method, impregnation method, curtain coating method and the combination thereof. Further the coated layer may be formed on one side or both sides of the film.

The adhesion layer of the invention also comprises preferably the combination (B) of the above-mentioned polyester resin (preferably copolymerized polyester) and polyurethane resin (preferably water-soluble, water-dispersible polyurethane).

The copolymerized polyester shows excellent adhesion to a polymer film such as polyester film, but occasionally poor adhesion to a transfer layer. In contrast, the polyurethane resin shows excellent adhesion to the transfer layer but occasionally poor adhesion to the polymer film such as polyester film.

The copolymerized polyester has as components dicarboxylic acid component and branched glycol component. Examples of the branched glycol component include 2,2-dimethyl-1,3-propane diol, 2-methyl-2-ethyl-1,3-propane diol, 2-methyl-2-butyl-1,3-propane diol, 2-methyl-2-propyl-1,3-propane diol, 2-methyl-2-isopropyl-1,3-propane diol, 2-methyl-2-n-hexyl-1,3-propane diol, 2,2-diethyl-1,3-propane diol, 2-ethyl-2-n-butyl-1,3-propane diol, 2-ethyl-2-n-hexyl-1,3-propane diol, 2,2-di-n-butyl-1,3-propane diol, 2-n-butyl-2-propyl-1,3-propane diol and 2,2-di-n-hexyl-1,3-propane diol.

The branched glycol component is preferably contained in the amount of not less than 10 mol%, further preferably not less than 20mol% based on the total glycol component. The glycol component other than the branched glycol component is most preferably ethylene glycol. Diethylene glycol, propylene glycol, butane diol, hexane diol, or 1,4-cyclohexane dimethanol can be used, provided that they are used in a little amount,.

The dicarboxylic acid component contained as constituent in the copolymerized polyester is most preferably terephthalic acid and isophthalic acid. Other carboxylic acids, for example, aromatic dicarboxylic acid such as diphenyl carboxylic acid and 2,6-naphthalene dicarboxylic acid can be copolymerized, provided that they are used in a little amount. In addition to the above dicarboxylic acids, 5-sulfoisophthalic acid is preferably used in the range of 1 to 10 mol% in order to give water dispersibility, and other than 5-sulfoisophthalic acid, sulfoterephthalic acid, 4-sulfonaphthalene isophthalic acid-2,7-dicarboxylc acid and 5-(4-sulfophenoxy)isophthalic aid, and salts thereof can be used.

The polyurethane resin used in the combination (B) is, for example, resin containing block type isocyanate group such as thermal-reactive water-soluble urethane resin having terminal isocyanate group blocked by a hydrophilic group or the like. Examples of the blocking agent (protecting agent) include bisulfate salts, and sulfonic acid group-containing phenols, alcohols, lactams, oximes and active methylene compounds. The blocked isocyanate group renders the urethane prepolymer hydrophilic or water-soluble. When the resin is heated in a drying or thermosetting process in the film preparation, the blocking agent is removed from the isocyanate group, whereby the resin is self-crossliked to form net structure. The water-dispersible copolymerized polyester is fixed on the mesh structure and simultaneously reacted with the terminal group or the like of the resin. The resin in the coating liquid has poor water resistance due to its hydrophilic property. However, after the completion of the coating, drying, thermosetting and thermo reaction, the hydrophilic group (i.e., blocking agent) of the urethane resin is removed, and the coated layer shows excellent water resistance.

Of the blocking agents, bisulfate salts are most preferable because of appropriate heat treatment temperature and time period, and widely used in industry. The composition of the urethane prepolymer used in the urethane resin comprises a compound having terminal isocyanate group obtained by the reaction of (1) organic polyisocyanate having two or more active hydrogen atoms in its molecule, or a compound having molecular weight of 200-20000 and two or more active hydrogen atoms in its molecule, (2) an organic polyisocyanate having two or more isocyanate groups in its molecule, or (3) a chain extender having two or more active hydrogen atoms in its molecule.

The (1) compound mentioned above generally contains two or more hydroxy groups, carboxyl groups, amino groups or mercapto groups in its terminal or molecule, and the particularly preferred compound is polyether polyol or polyetherester polyol. Examples of the polyether polyol include compounds obtained by the polymerization of alkylene oxide such as ethylene oxide and propylene oxide, or styrene oxide and epichlorohydrin, or by the random polymerization or block polymerization thereof, or by addition polymerization thereof to polyhydric alcohol.

Polyester polyol and polyetherester polyol generally are in the form of straight chain or branched chain. They can be obtained by the condensation of polybasic saturated or unsaturated acids such as succinic acid, adipic acid, phthalic acid and maleic acid anhydride or anhydrides thereof, with polyhydric saturated or unsaturated alcohols such as ethylene glycol, diethylene glycol, 1,4-butane diol, neopentyl glycol, 1,6-hexanediol and trimethylolpropane, polyalkylene ethers such as polyethylene glycol and polypropylene glycol having relatively low molecular weight, or a mixture thereof.

Also, polyesters obtained from lactone and hydroxy acid can be used as the polyester polyol, and polyetherester polyols obtained by adding ethylene oxide or propylene oxide to polyester prepared preliminarily can be used as the polyetherester polyol

Examples of the (2) organic polyisocyanate mentioned above include aromatic diisocyanates such as isomers of tolylene diisocyanate and 4,4-diphenylmethane diisocyanate, aromatic aliphatic diisocyanates such as xylylene diisocyanate, cycloaliphatic diisocyanates such as isophorone diisocyanate and 4,4-dicyclohexylmethane diisocyanate, aliphatic diisocyanates such as hexamethylene diisocyanate and 2,2,4-trimethylhexamethylene diisocyanate, or polyisocyanate obtained by adding one or plurality of these compounds to trimethylol propane.

Examples of the (3) chain extender having two or more active hydrogen atoms mentioned above include glycols such as ethylene glycol, diethylene glycol, 1,4-butane diol and 1,6-hexanediol, polyhydric alcohols such as glycerol, trimethylolpropane and pentaerythritol, diamines such as ethylene diamine, hexamethylene diamine, and piperazine, aminoalcohols such as monoethanol amine and diethanol amine, thiodiglycol such as thiodiethylene glycol, and water.

The urethane prepolymer can be generally synthesized by one-step or multi-step isocyanate poly-addition method using the chain extender under the reaction conditions of 150°C or less, preferably 70 to 120°C for 5 minutes to several hours. Although a ratio of isocyanate group to active hydrogen can be freely selected in the range of 1 or more, the resultant urethane prepolymer is required to have free isocyanate group. Further, the content of the free isocyanate group generally is not more than 10% by weight, whereas the content of the free isocyanate group preferably is not more than 7% by weight in view of the stability of an aqueous solution of urethane polymer blocked later.

The resultant urethane prepolymer is preferably blocked by using bisulfate salts. The reaction is carried out by mixing it with an aqueous solution of bisulfate salt, stirring sufficiently the mixture for 5 minutes to 1 hour whereby the reaction proceeds. The reaction temperature is preferably not more than 60°C. Thereafter, the reaction mixture is diluted with water to an appropriate concentration to form a thermo-reaction type water-soluble urethane composition. The composition is adjusted to appropriate concentration and viscosity when it is used. However, in case the composition is heated at approx. 80 to 100°C, the bisulfate salt of blocking agent dissociates to regenerate an active isocyanate group. Therefore the resultant composition has the properties that polyaddition reaction occurring within molecule or between molecules brings about formation of polyurethane polymer or addition to other functional groups.

As one example of resin having blocked isocyanate group, Erastron available from Dai-ichi Kogyo Seiyaku Co., Ltd. can be typically mentioned. The Erastron is prepared by blocking isocyanate groups with sodium bisulfate and provided with a carbamoyl sulfonate group having strong hydrophilic property, and hence the Erastron is soluble in water.

In case the copolymerized polyester resin containing branched glycol component (a) and the resin containing blocked isocyanate group (b), which are used in the combination (B), are mixed with each other to prepare a coating liquid, a ratio by weight of the resin (a) and the resin (b) is preferably (a):(b)=90:10 to 10:90, further preferably (a):(b)=80:20 to 20:80. When the ratio of the resin (a) to the solid content is less than 10% by weight, coating properties on a polymer film becomes poor and adhesion between the film and a surface layer is insufficient. When the ratio of the resin (b) to the solid content is less than 10% by weight, adhesion to a transfer layer is insufficient to be of no practical use.

The coating liquid of the combination (B) is preferably an aqueous liquid. In case the coating liquid is applied onto the polymer film mentioned above, known anionic surface active agents and nonionic surface active agents can be added in necessary amount to the liquid. Solvents used in the liquid include in addition to water, alcohols such as ethanol, isopropyl alcohol and benzyl alcohol, and the alcohols may be contained in the total coating liquid up to less than 50% by weight. Further organic solvents other than alcohols may be contained in the amount of less than 10% by weight as long as it is soluble. However, the total amount of the alcohols and the other organic solvent is less than 50% by weight based on the coating liquid.

When the added amount of the organic solvent is less than 50% by weight, drying property of the coated layer is enhanced and simultaneously the appearance of the coated layer is also improved compared with that formed from a coating liquid containing only water. When the added amount of the organic solvent is not less than 50% by weight, the solvent vaporizes in high speed to bring about the variation of the concentration of the coated layer, whereby the viscosity of the coated layer increases to bring about occasionally poor appearance of the coated layer, and further to increase risk of occurrence of a fire.

The adhesion layer of the invention generally is in the range of 0.01 to 0.3µm, especially 0.02 to 0.2µm.

The photo-curable transfer sheet used in the present invention generally comprises the adhesive transparent film mentioned above and the photo-curable transfer layer comprising a photo-curable composition deformable by application of pressure which is provided on the film.

The photo-curable composition of the invention is generally composed mainly of a polymer (preferably one having a glass transition temperature of not less than 80°C) and a reactive diluent (generally monomer or oligomer) having a photopolymerizable functional group (generally carbon-carbon double bond, preferably (meth)acryloyl group), a photopolymerization initiator and if necessary other additives. Further the composition preferably contains a lubricant.

Particularly, the photo-curable transfer layer used in the intermediate stamper preferably contains a lubricant. The lubricant preferably is a phosphorus atom-containing compound or modified polysiloxane, especially (meth)acryloyl group-containing polysiloxane. The (meth)acryloyl group may bond to polysiloxane through polyalkylene oxide.

In the method for forming a fine concave-convex pattern such as a nanoimprint method, the reduction of a tact time is important in order to enhance productivity and decrease cost. In case the peel property (mold release characteristics) of the stamper from the sheet is not good, it is difficult to reduce the tact time. Since the sheet having the cured transfer layer obtained after the peel of the stamper is so flexible or limp that it cannot have sufficient film self-supporting property, it is difficult that the sheet acquires sufficient handling properties such as mobility and winding property. Hence, the use of the lubricant greatly improves the handling properties.

Examples of the polysiloxane include dimethyl silicone, methyl phenyl silicone, methyl hydrogen silicone. Examples of the modified polysiloxane include the above-mentioned polysiloxane having a functional group at side chain, one end or both ends. Examples of the functional group include an amino group, an epoxy group, a cycloaliphatic epoxy group, a carbinol group, a mercapto group, a carboxyl group, an acryloyl group and a methacryloyl group. Preferred is the modified polysiloxane, especially acryloyl group and/or methacryloyl group modified polysiloxane. The (meth)acryloyl group may bond to polysiloxane through polyalkylene oxide.

In case the polysiloxane or modified polysiloxane is used as the lubricant, the lubricant is preferably contained in the photo-curable composition (nonvolatile content) in an amount of 0.1 to 20% by weight, especially 0.5 to 20% by weight. The use of more than 20% by weight of the lubricant causes reduction of the adhesion to the transparent film, whereas the use of less than 0.1% by weight of the lubricant does not bring about sufficient peeling property from the stamper or the like.

The phosphorus atom-containing compound is also preferred as the lubricant. Examples of the phosphorus atom-containing compound include phosphoric acid ester compounds such as a phosphoric acid alkylpolyoxyalkylene compound and a phosphoric acid alkyl ester compound, phosphate salts and amide phosphates.

Examples of the phosphoric acid ester compounds include phosphoric acid trialkyl ester (e.g., trioctyl phosphate, octyl diphenyl phosphate, trischloroethyl phosphate), and phosphoric acid triaryl ester (e.g., tricresyl phosphate, tritolyl phosphate). Examples of the phosphate salts include sodium salts of phosphoric acid (e.g., sodium dihydrogen phosphate, disodium hydrogen phosphate, sodium phosphate, tetrasodium pyrophosphate, sodium metaphosphate, sodium tripolyphosphate). Examples of the amide phosphates include (e.g., tris(ethyleneimino)phosphoric amide, tris(methylethyleneimino)phosphoric amide. Further, there can be mentioned phospholipid surface active agents (e.g., lecitin), and chlorine compounds of phosphorus (e.g., phosphorous trichloride, phosphorous pentachloride, phosphorous oxychloride).

As the phosphorus atom-containing compound of the invention, preferred is the phosphoric acid alkyl ester compound, especially the phosphoric acid alkylpolyoxyalkylene compound or the phosphoric acid ester type anion surface active agent.

As the phosphorus atom-containing compound, it is preferred to use the compound represented by the following formula (I):

[ka 3]

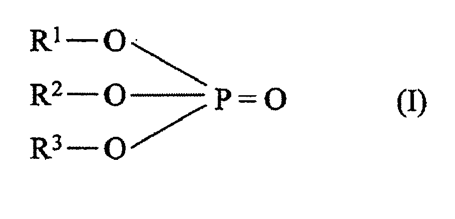

in which R¹, R² and R³ independently with each other represent a hydrogen atom, an alkyl group, an aryl group, an alkylaryl group, an arylalkyl group, an alkylpolyoxyalkylene group, or an arylpolyoxyalkylene group, each of these groups may have a substituent group, and at least one of R¹, R² and R³ represent the groups other than a hydrogen atom.

In the formula (I), the alkyl group generally is an alkyl group of 1 to 10 carbon atoms, the aryl group generally is a phenyl group, the alkylaryl group generally is a phenyl group having an alkyl group of 1 to 3 carbon atoms, the arylalkyl group generally is a phenyl alkyl group (the alkyl group is an alkyl group of 1 to 3 carbon atoms), the alkylpolyoxyalkylene group generally is alkylpolyoxyethylene group having 5 to 20 carbon atoms or alkylpolyoxypropylene group having 7 to 20 carbon atoms, and the arylpolyoxyalkylene group generally is alkylphenylpolyoxyethylene group having 10 to 30 carbon atoms, or alkylphenylpolyoxypropylene group having 12 to 30 carbon atoms, or phenylpolyoxyethylene group having 9 to 30 carbon atoms, or phenylpolyoxypropylene group having 11 to 30 carbon atoms. The substituents of these groups include halogen (especially chlorine, bromine), alkyl ammonium salts (especially -N⁺(CH₃)₃), and a vinyl group. All of R¹, R² and R³ preferably represent the groups other than a hydrogen atom, and all of R¹, R² and R³ preferably are the same groups.

The phosphorus atom-containing compound (I) is a phosphoric acid alkylpolyoxyalkylene compound represented by the following formula (II):

[ka 4]

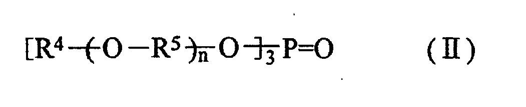

in which R⁴ represents an alkyl group, an aryl group, an alkylaryl group or an arylalkyl group, each of these groups may have a substituent group, R⁵ represents -CH₂CH₂- or -CH(CH₃) CH₂-, and n is 1 to 20.

In the R⁴, the alkyl group generally represents an alkyl group of 1 to 20 carbon atoms (e.g., methyl, ethyl, propyl, butyl, octyl, cetyl), especially an alkyl group of 4 to 18 carbon atoms, the aryl group generally represents a phenyl group, the alkylaryl group generally represents a phenyl group having an alkyl group of 1 to 3 carbon atoms (especially methylphenyl), and the arylalkyl group generally represents a phenyl alkyl group (especially the alkyl group is an alkyl group of 1 to 3 carbon atoms). The substituents of these groups include halogen (especially chlorine, bromine). However, these groups preferably have no substituent.

Further, R⁵ preferably represents -CH₂CH₂-. n is preferably 1 to 10, especially 2 to 5.

The phosphoric acid alkylpolyoxyalkylene compound of the formula (II) is available as Trade name: LTP-2 manufactured by Kawaken Fine Chemicals Co.,Ltd., and Trade name: N3A and Trade name: N10A manufactured by Croda Japan KK. The N3A is a compound represented by the formula I in which R¹ is octyl, R² is -CH₂CH₂-, n is 3. The N10A is a compound represented by the formula I in which R¹ is octyl, R² is -CH₂CH₂-, n is 10.

In case the phosphorus atom-containing compound is used as the lubricant, the compound is preferably contained in the photo-curable composition (nonvolatile content) in the amount of 0.01 to 1% by weight, further preferably 0.01 to 0.5% by weight, especially 0.02 to 0.2% by weight. The use of more than 1% by weight of the compound causes reduction of the adhesion to the transparent film, whereas the use of less than 0.01 % by weight of the compound does not bring about sufficient peeling property from the stamper or the like.

Examples of the reactive diluent having a photopolymerizable functional group, which is a structural requirement of the invention, include,
(meth)acrylate monomers such as 2-hydroxyethyl (meth)acrylate, 2-hydroxypropyl (meth)acrylate, 4-hydroxybutyl (meth)acrylate, 2-hydroxy-3-phenyloxypropyl (meth)acrylate, 2-ethylhexyl (meth)acrylate, 2-ethylhexylpolyethoxy (meth)acrylate, benzyl (meth)acrylate, isobornyl (meth)acrylate, phenyloxyethyl (meth)acrylate, tricyclodecane mono(meth)acrylate, dicyclopentenyloxyethyl (meth)acrylate, tetrahydrofurfuryl (meth)acrylate, acryloylmorpholine, N-vinylcaprolactam, o-phenylphenyloxyethyl (meth)acrylate, 2-hydroxy-3-acryloyloxypropyl methacrylate,
neopentylglycol di(meth)acrylate, neopentyl glycol dipropoxy di(meth)acrylate, neopentyl glycol hydroxypivalate di(meth)acrylate, tri-cyclodecanedimethylol di(meth)acrylate, 1,6-hexanediol di(meth)acrylate, nonanediol di(meth)acrylate,
glycerol diacrylate, glycerol acrylate methacrylate, glycerol dimethacrylate, trimethylolpropane diacrylate, trimethylolpropane acrylate methacrylate, trimethylolpropane dimethacrylate,
trimethylolpropane tri(meth)acrylate, pentaerythritol tri(meth)acrylate, pentaerythritol tetra(meth)acrylate, tris[(meth)acryloxyethyl]isocyanurate and ditrimethylolpropane tetra(meth)acrylate; and
the following (meth)acrylate oligomer such as:
polyurethane (meth)acrylate such as compounds obtained by reaction of:
   a polyol compound (e.g., polyol such as ethylene glycol, propylene glycol, neopentyl glycol, 1,6-hexanediol, 3-methyl-1,5-pentanediol, 1,9-nonanediol, 2-ethyl-2-butyl-1,3-propanediol, trimethylolpropane, diethylene glycol, dipropylene glycol, polypropylene glycol, 1,4-dimethylolcyclohexane, bisphenol-A polyethoxydiol and polytetramethylene glycol; polyesterpolyol obtained by reaction of the above-mentioned polyol and polybasic acid or anhydride thereof such as succinic acid, maleic acid, itaconic acid, adipic acid, hydrogenated dimer acid, phthalic acid, isophthalic acid and terephthalic acid; polycaprolactone polyol obtained by reaction of the above-mentioned polyol and ε-caprolactone; a compound obtained by reaction of a reaction product of the above-mentioned polyol and the above-mentioned polybasic acid or anhydride thereof and ε-caprolactone; polycarbonate polyol; or polymer polyol), and
   an organic polyisocyanate compound (e.g., tolylene diisocyanate, isophorone diisocyanate, xylylene diisocyanate, diphenylmethane-4,4'-diisocyanate, dicyclopentanyl diisocyanate, hexamethylene diisocyanate, 2,4,4'-trimethylhexamethylene diisocyanate, 2,2',4'-trimethylhexamethylene diisocyanate), and
   hydroxyl-containing (meth)acrylate (e.g., 2-hydroxyethyl (meth)acrylate, 2-hydroxyropyl (meth)acrylate, 4-hydroxybutyl (meth)acrylate, 2-hydroxy-3-phenyloxypropyl (meth)acrylate, cyclohexane-1,4-dimethylolmono(meth)acrylate, pentaerythritol tri(meth)acrylate or glycerol di(meth)acrylate);
   bisphenol-type epoxy(meth)acrylate obtained by reaction of bisphenol-A epoxy resin or bisphenol-F epoxy resin and (meth)acrylic acid.
These compounds having photopolymerizable functional group can be employed singly or in combination of two or more kinds.

Examples of the polymer (preferably one having glass transition temperature of not less than 80°C) include acrylic resin, polyvinyl acetate, vinyl acetate/ (meth)acrylate copolymer, ethylene/vinyl acetate copolymer, polystyrene and copolymer thereof, polyvinyl chloride and copolymer thereof, butadiene/acrylonitrile copolymer, acrylonitrile/butadiene/styrene copolymer, methacrylate/acrylonitrile/butadiene/styrene copolymer, 2-chlorobutasiene-1,3-polymer, chlorinated rubber, styrene/butadiene/styrene copolymer, styrene/isoprene/styrene block copolymer, epoxy resin, polyamide, polyester, polyurethane, cellulose ester, cellulose ether, polycarbonate, polyvinyl acetal.

In the invention, the polymer preferably is acrylic resin in view of excellent transferring property and high curing property. Especially preferred is acrylic resin having a polymerizable functional group or acrylic resin having a hydroxyl group as mentioned above. The acrylic resin preferably has a recurring unit of methyl methacrylate in the amount of not less than 50% by weight, especially 60 to 90% by weight, because the glass transition temperature of not less than 80°C are easily obtained and excellent transferring property and high curing property are also easily obtained. As the acrylic resin having a polymerizable functional group, for example, POREAS-7 (manufactured by Osaka Organic Chemical Industry Ltd.) can be preferably used.

The acrylic resin having a polymerizable functional group generally is a copolymer of methyl methacrylate, at least one alkyl (meth)acrylate whose alkyl has 2 to 10 carbon atoms and glycidyl (meth)acrylate, the glycidyl group being reacted with carboxylic acid having a photopolymerizable functional group; or
a copolymer of methyl methacrylate, at least one alkyl (meth)acrylate whose alkyl has 2 to 10 carbon atoms and carboxylic acid having a photopolymerizable functional group, a carboxyl group of the carboxylic acid being reacted with glycidyl (meth)acrylate.
The copolymer of methyl methacrylate, at least one alkyl (meth)acrylate whose alkyl has 2 to 10 carbon atoms and glycidyl (meth)acrylate or carboxylic acid having a photopolymerizable functional group, preferably has at least 50% by weight of recurring unit of methyl methacrylate, especially 60 to 90% by weight of recurring unit of methyl methacrylate. An appropriate combination of the acrylic resin with the reactive diluent enables the achievement of both of excellent transferring property and high curing property. Examples of the alkyl (meth)acrylate whose alkyl has 2 to 10 carbon atoms (especially 3 to 5 carbon atoms) include ethyl (meth)acrylate, n-propyl (meth)acrylate, isopropyl (meth)acrylate, n-butyl (meth)acrylate, isobutyl (meth)acrylate, 2-ethylhexyl (meth)acrylate. Preferred are n-butyl (meth)acrylate, isobutyl (meth)acrylate, 2-ethylhexyl (meth)acrylate. The alkyl (meth)acrylate is preferably contained as recurring unit in the amount of 5 to 30% by weight, especially 10 to 30% by weight, in the polymer. The glycidyl (meth)acrylate or carboxylic acid having a photopolymerizable functional group is preferably contained as recurring unit in the amount of 5 to 25% by weight, especially 5 to 20% by weight, in the polymer. The glycidyl group or carboxyl group of the resultant copolymer is reacted with carboxylic acid having a photopolymerizable functional group or glycidyl (meth)acrylate, respectively.

The acrylic resin having hydroxyl group generally is a copolymer of methyl methacrylate, at least one alkyl (meth)acrylate whose alkyl has 2 to 10 carbon atoms (especially 3 to 5 carbon atoms) and at least one hydroxyalkyl (meth)acrylate whose hydroxyalkyl has 2 to 4 carbon atoms. The methyl methacrylate is preferably contained as recurring unit in the amount of at least 50% by weight, especially 60 to 90% by weight in the polymer. An appropriate combination of the acrylic resin with the reactive diluent enables the achievement of both of excellent transferring property and high curing property. Examples of the alkyl (meth)acrylate whose alkyl has 2 to 10 carbon atoms (especially 3 to 5 carbon atoms) include ethyl (meth)acrylate, n-propyl (meth)acrylate, isopropyl (meth)acrylate, n-butyl (meth)acrylate, isobutyl (meth)acrylate, 2-ethylhexyl (meth)acrylate. Preferred are n-butyl (meth)acrylate, isobutyl (meth)acrylate, 2-ethylhexyl (meth)acrylate. The alkyl (meth)acrylate is preferably contained as recurring unit in the amount of 5 to 30% by weight, especially 10 to 30% by weight, in the polymer. Examples of the hydroxyalkyl (meth)acrylate whose hydroxyalkyl has 2 to 4 carbon atoms include 2-hydroxyethyl methacrylate, hydroxypropyl methacrylate. The hydroxyalkyl (meth)acrylate is preferably contained as recurring unit in the amount of 5 to 25% by weight, especially 5 to 20% by weight, in the polymer.

The acrylic resin having a polymerizable functional group is, for example, prepared as follows:

One or plural (meth)acrylate(s) (preferably methyl methacrylate and at least one alkyl (meth)acrylate whose alkyl has 2 to 10 carbon atoms as mentioned above) is reacted with a compound having a glycidyl group and a photopolymerizable functional group (preferably glycidyl (meth)acrylate), or with a carboxylic acid having a photopolymerizable functional group in the presence of a radical polymerization initiator and an organic solvent according to a known polymerization process such as a solution polymerization process, whereby glycidyl group-containing acrylic resin (a) or carboxyl group-containing acrylic resin (b) is obtained. The alkyl (meth)acrylate is preferably contained in the amount of 10 to 45% by weight in terms of solid based on the glycidyl group-containing acrylic resin (a) or carboxyl group-containing acrylic resin (b).

Subsequently, carboxylic acid having a photopolymerizable functional group is added to the glycidyl group-containing acrylic resin (a), or a compound having a glycidyl group and a photopolymerizable functional group (preferably glycidyl (meth)acrylate) is added to the carboxyl group-containing acrylic resin (b), with if necessary heating to prepare an acrylic photocurable resin (A) or an acrylic photocurable resin (B). A molar ratio of carboxyl group to glycidyl group is generally 1/0.9 to 1/1, preferably 1/1. Excess glycidyl group may bring about disadvantages in long-term stability such as increase of viscosity or gelation, whereas excess carboxyl group reduces workability due to increase of skin irritation. Further, the ratio of 1/1 brings about disappearance of glycidyl group to extremely enhance storage stability. The reaction can be carried out according to known methods in the presence of base catalyst or phosphorous catalyst.

The (meth)acrylate monomers as chief ingredient of the acrylic resin used in the invention, the acrylic resin including the acrylic resin having a photopolymerizable functional group or hydroxyl group, include various esters of acrylic acid or methacrylic acid. Examples of the esters of acrylic acid or methacrylic acid include alkyl(meth)acrylates such as methyl (meth)acrylate [the (meth)acrylate means acrylate and methacrylate, hereinafter in the same manner], ethyl (meth)acrylate, n-propyl (meth)acrylate, n-butyl (meth)acrylate, isobutyl (meth)acrylate, t-butyl (meth)acrylate, 2-ethylhexyl (meth)acrylate, stearyl (meth)acrylate, lauryl (meth)acrylate and tridecyl (meth)acrylate; alkoxyalkyl(meth)acrylates such as ethoxyethyl(meth)acrylate and butoxyethyl(meth)acrylate; alkoxyalkoxyalkyl(meth)acrylates such as 2-methoxyethoxyethyl(meth)acrylate and 2-ethoxyethoxyethyl (meth)acrylate; alkoxy (poly)alkylene glycol (meth)acrylates such as methoxy diethylene glycol (meth)acrylate, ethoxy diethylene glycol (meth)acrylate, methoxy triethylene glycol (meth)acrylate, butoxy triethylene glycol (meth)acrylate and methoxy dipropylene glycol (meth)acrylate; dialkylaminoalkyl(meth)acrylates such as pyrenoxide adduct (meth)acrylates, N,N-dimethylaminoethyl (meth)acrylate and N,N-diethylaminoethyl (meth)acrylate. Further there can be mentioned aromatic compounds having unsaturated group (e.g., styrene).

In the invention, it is preferred to use methyl methacrylate and at least one alkyl (meth)acrylate whose alkyl has 2 to 10 carbon atoms.

The polymer (preferably one having a glass transition temperature of not less than 80°C), preferably has number average molecular weight of not less than 100,000, especially 100,000 to 300,000, and weight average molecular weight of not less than 100,000, especially 100,000 to 300,000.

As the polymer having a glass transition temperature of not less than 80°C the invention, acrylic resin having both of a photopolymerizable functional group and an active hydrogen containing functional group such as a hydroxyl group can be also used. Such reactive polymer generally is a homopolymer or copolymer (i.e., acrylic resin) which is obtained from the above-mentioned (meth)acrylates and which has a photopolymerizable functional group and a functional group having active hydrogen in its main chain or side chain. Hence the homopolymer or copolymer can be obtained, for example, by copolymerizing methyl methacrylate, one or more (meth)acrylate mentioned above with (meth)acrylate (e.g., 2-hydroxyethyl (meth)acrylate) having a functional group such as a hydroxyl group, and reacting the resultant polymer with a compound (e.g., isocyanatoalkyl (meth)acrylate) having a functional group capable of reacting with the active hydrogen-containing group of the polymer and having a photopolymerizable functional group. In the latter reaction, the amount of the compound (e.g., isocyanatoalkyl (meth)acrylate) having a functional group capable of reacting with the hydroxyl group is adjusted so as to leave the hydroxyl group. Thus, the polymer having the photopolymerizable functional group and the hydroxyl group as the active hydrogen-containing group can be obtained.

Otherwise, the use of (meth)acrylate (e.g., 2-aminoethyl (meth)acrylate) having an amino group instead of the hydroxyl group in the reaction results in a polymer having the photopolymerizable functional group and the amino group as the active hydrogen-containing group. Similarly a polymer having the photopolymerizable functional group and a carboxyl group as the active hydrogen-containing group can be obtained.

In the invention, it is also preferred to use acrylic resin having a photopolymerizable group through urethane bond.

The polymer having both of a photopolymerizable functional group has generally 1 to 50% by mole, preferably 5 to 30% by mole of the photopolymerizable functional group. Examples of the photopolymerizable functional group preferably include acryloyl, methacryloyl and vinyl groups, especially acryloyl and methacryloyl groups.

Examples of diisocyanate usable in the photo-curable composition of the invention include tolylene diisocyanate (TDI), isophorone diisocyanate, xylylene diisocyanate, diphenylmethane-4,4'-diisocyanate, dicyclopentyl diisocyanate, hexamethylene diisocyanate, 2,4,4'-trimethylhexamethylene diisocyanate, 2,2',4-trimethylhexamethylene diisocyanate. Further three or more functional isocyanate compounds such as TDI adduct of trimethylol propane and hexamethylene diisocyanate adduct of trimethylol propane can be employed. Of these compounds, hexamethylene diisocyanate adduct of trimethylol propane is preferred.

The diisocyanate is preferably contained in the amount of 0.2 to 4% by weight, especially 0.2 to 2% by weight in the photo-curable composition, which results in appropriate crosslinking of the transfer layer to prevent the transfer layer from exudation with maintaining good transfer property between the transfer layer and the concavo-convex surface of substrate or stamper. The reaction of the diisocyanate with the polymer gradually progresses after the provision of the transfer layer, for example, progresses to a large degree at a room temperature (generally 25°C) for 24 hours. Also it is considered that the polymer and diisocyanate in a coating solution for forming the transfer layer are slightly reacted with each other during the term from its preparation to its coating. Because it is preferred that the transfer layer is cured to some degree between the provision of the transfer layer and the rolling up of the resultant transfer layer, the curing of transfer layer may be promoted by heating during or after of the provision of the transfer layer, or before the rolling up.

As mentioned above, the photo-curable composition is generally composed mainly of the specific lubricant, the polymer having a glass transition temperature of not less than 80°C and a reactive diluent (generally monomer and oligomer) having a photopolymerizable functional group (preferably (meth)acryloyl group), a photopolymerization initiator and if necessary other additives.

The photo-curable transfer layer of the invention generally has storage elastic modulus of not more than 1×10⁷Pa which is determined on the conditions of frequency of 1Hz and a temperature of 25°C, especially the storage elastic modulus of 1×10⁴Pa to 6×10⁵Pa. Further, the storage elastic modulus at 80°C is preferably not more than 8×10⁴Pa, especially 1×10⁴Pa to 5×10⁵Pa. Thereby, accurate and speedy transfer is ensured. Further, the photo-curable transfer layer of the invention generally has a glass transition temperature of less than 20°C. Thereby, in case the resultant photo-curable layer is depressed to a concave-convex surface of a stamper, the photo-curable layer follows accurately the uneven surface even at room temperature to have good flexibility. The photo-curable transfer layer especially has a glass transition temperature of 15 to -50°C, especially 0 to -40°C whereby the resultant photo-curable layer follows more accurately the uneven surface. When the glass transition temperature exceeds the upper limit, increased pressure and temperature are needed in the depressing and bonding steps of the sheet, which brings about lowering of workability. When the glass transition temperature falls to below the lower limit, the resultant cured sheet does not have sufficient hardness.

Further, the photo-curable transfer layer comprising the photo-curable composition is preferably configured such that the layer having been subjected to ultraviolet exposure of 300 mJ/cm² has a glass transition temperature of not less than 65°C. The brief exposure easily prevents sagging of concave shape, which is apt to occur due to residual stress generated in transferring, whereby the transferred shape of concave and the like can be maintained.
The photo-curable transfer layer comprising the photo-curable composition can be advantageously obtained by using the above-mentioned polymer and the reactive diluent.

Any known photopolymerization initiators can be used in the invention. The initiators having good storage-stability after mixing with other integrants are preferred. Examples of the photopolymerization initiators include acetophenone type initiators; benzoin type initiators such as benzylmethylketal; benzophenone type initiators; thioxanthone type initiators such as isopropylthioxanthone and 2,4-diethythioxanthone. Further, as special type, there can be mentioned methylphenylglyoxylate. Especially preferred are 2-hidroxy-2-methyl-1-phenylpropane-1-on, 1-hydroxycyclohexylphenylketone, 2-methyl-1-[4-(methylthio)phenyl]-2-morphorinopropane-1 and benzophenone. These photopolymerization initiators can be employed together with one or more kinds of a photopolymerization promoter such as a benzoic acid type compound (e.g., 4-dimethylaminobezoic acid) or a tertiary amine compound by mixing the initiator with the promoter in optional ratio. The initiator can be employed singly or in combination of two or more kinds. The initiator is preferably contained in the photo-curable composition (nonvolatile content) in the range of 0.1 to 20% by weight, especially 1 to 10% by weight.

Of the above-mentioned photopolymerizable initiators, examples of the acetophenone type initiator include 4-phenoxydichloroacetophenone, 4-t-butyldichloroacetophenone, 4-t-butyltrichloroacetophenone, diethoxyacetophenone, 2-hydroxy-2-methyl-1-phenylpropane-1-on, 1-(4-isopropylphenyl)-2-hidroxy-2-methylpropane-1-on, 1-(4-dodecylphenyl)-2-hydroxy-2-methylpropane-1-on, 4-(2-hydroxyethoxy)-phenyl(2-hydroxy-2-propyl)ketone, 1-hydroxycyclohexylphenylketone, 2-methyl-1-[4-(methylthio)phenyl]-2-morphorino-propane-1-on; and examples of the benzophenone type initiator include benzophenone, benzoylbenzoic acid, methyl benzoylbenzoate, 4-phenylbenzophenone, hydroxybenzophenone, 4-benzoyl-4'-methylphenylsulfide and 3,3'-dimethyl-4-methoxybenzophenone.

The acetophenone type initiators especially are 2-hydroxy-2-methyl-1-phenylpropane-1-on, 1-hydroxycyclohexylphenylketone and 2-methyl-1-[4-(methylthio)phenyl]-2-morphorinopropane-l, and the benzophenone type initiators preferably are benzophenone, benzoylbenzoic acid and methyl benzoylbenzoate.
Preferred examples of the tertiary amine compounds of the photopolymerization promoter include triethanolamine, methyldiethanolamine, triisopropanolamine, 4,4'-dimethylaminobenzophenone, 4,4'-diethylaminobenzophenone, ethyl 2-dimethylaminobenzonate, ethyl 4-dimethylaminobenzonate, (n-butoxy)ethyl 4-dimethylaminobenzonate, isoamyl 4-dimethylaminobenzonate and 2-ethylhexyl 4-dimethylaminobenzonate. Especially preferred are ethyl 4-dimethylaminobenzonate, (n-butoxy)ethyl 4-dimethylaminobenzonate, isoamyl 4-dimethylaminobenzonate and 2-ethylhexyl 4-dimethylaminobenzonate.

The photo-curable composition preferably contains, in addition to the reactive diluent having a photopolymerizable functional group and the photopolymerization initiator, if desired the following thermoplastic resin and other additives.

As other additives, a silane coupling agent (adhesion promoter) can be used for enhancing adhesive strength (adhesion). Examples of the silane coupling agent include vinyltriethoxysilane, vinyl-tris(β-methoxyethoxy)silane, γ-methacryloxypropylmethoxysilane, vinyltriacetoxysilane, γ-glycidoxypropyltrimethoxysilane, γ-glycidoxypropyltriethoxysilane, β-(3,4-epoxycyclohexyl)ethyltrimethoxysilane, γ-chloropropylmethoxysilane, vinyltrichlorosilane, γ-mercaptopropylmethoxysilane, γ-aminopropyltriethoxysilane, N-β-(aminoethyl)-γ-aminopropyltrimethoxysilane. The silane coupling agent can be used singly, or in combination of two or more kinds. The silane coupling agent is preferably used in the range of 0.01 to 5 weight by part based on 100 parts by weight of the above polymer (solid content).

Similarly, an epoxy group-containing compound can be used for enhancing the adhesive strength. Examples of the epoxy group-containing compounds include triglycidyl tris(2-hydroxyethyl)isocyanurate, neopentylglycol diglycidyl ether, 1,6-hexanediol diglycidyl ether, allyl glycidyl ether, 2-ethylhexyl glycidyl ether, phenyl glycidyl ether, phenol glycidyl ether, p-tert-butylphenyl glycidyl ether, diglycidyl adipate, diglycidyl o-phthalate, glycidyl methacrylate and butyl glycidyl ether. Further, the similar effect is also obtained by using an oligomer having an epoxy group and molecular weight of hundreds to thousands, or a polymer having an epoxy group and molecular weight of thousands to hundreds of thousands. The content of the compound having an epoxy group is sufficient in the range of 0.1 to 20 parts by weight based on 100 parts by weight of the reactive polymer (solid content). At least one of the compounds having an epoxy group can be used singly or in combination of two or more kinds.

As other additives, further a hydrocarbon resin can be used for improving processing properties such as laminating properties. The hydrocarbon resin may be either natural resin or synthetic resin. Examples of the natural resins preferably include rosins, rosin derivatives and terpene resins. Examples of the rosins include gum resins, tall oil resins, wood resins. Examples of the rosin derivatives include hydrogenated rosins, disproportionated rosins, polymerized rosins, esterificated rosins, metal salts of rosins. Examples of the terpene resins include α-pinene resins, β-pinene resins, and terpene phenol resins. Moreover, as the natural resin, dammar, copal, shellac can be used. Examples of the synthetic resins preferably include petroleum resins, phenol resins, and xylene resins. Examples of the petroleum resins include aliphatic petroleum resins, aromatic petroleum resins, cycoaliphatic petroleum resins, copolymer type petroleum resins, hydrogenated petroleum resins, pure monomer type petroleum resins, and coumarone-indene resins. Examples of the phenol resins include alkylphenol resins and modified phenol resins. Examples of the xylene resins include xylene resins and modified xylene resins.

The resin such as the hydrocarbon polymer resin can be used in the amount of 1 to 20 parts by weight, preferably 5 to 15 parts by weight based on 100 parts by weight of the polymer (solid content) of the invention

The photo-curable composition may contain, in addition to the above-mentioned additives, an ultraviolet absorber, an aging resistant agent, a dye, and a processing auxiliary agent in a small amount. If desired, particles of silica gel, calcium carbonate or silicone copolymer may be contained in a small amount.

The photo-curable transfer sheet comprising the photo-curable composition of the invention is generally prepared, for example, by homogeneously mixing the specific phosphorous-containing compound, the polymer (preferably polymer having Tg of not less than 80°C), the compound diluent having a photopolymerizable functional group (monomer and oligomer) and if desired, the diisocyanate and other additives, kneading the mixture by using an extruder or roll, and subjecting the kneaded mixture to a film-forming process using a calendar, roll, T-die extrusion or inflation to form a film of a predetermined shape. The photo-curable layer is generally formed on the adhesion layer of the adhesion film. A more preferred process for forming the photo-curable sheet comprises the steps of dissolving homogeneously the ingredients in a good solvent, applying the resultant solution onto the adhesion layer of the adhesion film or a separator coated closely with silicone or fluoric resin (or the support) by means of flow-coater method, roll-coater method, gravure-roll method, mayer-bar method or lip-die coating method, and vaporizing the solvent.

The thickness of the photo-curable transfer layer generally is in the range of 1 to 1,200µm, preferably 5 to 500µm, especially 5 to 300µm (preferably not more than 150µm). When the thickness is thinner than 1µm, sealing properties are lowered. When the thickness is thicker than 1,200µm, the thickness of the resultant molded product is so thick that trouble in housing or assembly of the molded product.

The photo-curable transfer layer preferably has a thickness of 1 to 300µm, especially 3 to 100µm.

The photo-curable transfer sheet preferably has a release sheet on another side having no photo-curable transfer and adhesion film.

The release sheet is generally composed chiefly of a plastic film and a release layer having low surface tension such as silicone. The release layer comprises, for example, condensation reaction product of polysiloxane having hydroxy group and hydrogenated polysiloxane, or product formed from polysiloxane (preferably dimethyl polysiloxane) having unsaturated double-bond group (preferably vinyl group) and hydrogenated polysiloxane (preferably dimethyl polysiloxane).

The plastic film of the release sheet generally is a transparent film consisting chiefly of transparent organic resin. Examples of the transparent organic resin include polyester resin (e.g., polyethylene terephthalate, polycyclohexylene terephthalate, polyethylene naphthalate), polyamide (e.g., nylon 46, modified nylon 6T, nylon MXD6, polyphthalamide), ketone resin (e.g., polyphenylene sulfide, polythioether sulfone), sulfone resin (e.g., polysulfone, polyether sulfone), polyether nitrile, polyarylate, polyether imide, polyamideimide, polycarbonate, polymethyl methacrylate, triacetylcellulose, polystyrene or polyvinyl chloride. Of these resins, polycarbonate, polymethyl methacrylate, polyvinyl chloride, polystyrene and polyethylene terephthalate can be preferably employed. The thickness is generally in the range of 10 to 200µm, especially in the range of 30 to 100µm.

The photo-curable transfer sheet of the invention is generally composed of the photo-curable transfer layer consisting of the photo-curable composition which is easily deformable by application of pressure, the adhesion film provided on one side of the layer, and the release sheet on the other side. The photo-curable transfer layer has been preferably subjected to annealing treatment. In more detail, it is preferred to use the annealed photo-curable transfer sheet to form concave-convex pattern. The annealing treatment is preferably carried out by string the layer at 30 to 100°C especially 40 to 70°C, for 1 hour to 30 days, especially 10 hour to 10 days. The transfer sheet is preferably subjected to annealing treatment in the form of roll (in winding state). The annealing treatment promotes movement of a component promoting release (demolding component) to the photo-curable transfer layer whereby it is considered that the stamper can be easily removed.

The photo-curable transfer sheet of the invention can be provided in the form of film that the thickness is accurately controlled, and hence the bonding (lamination) between the sheet and a mold such as a stamper can be easily and accurately carried out. This bonding can be easily carried out by depressing the sheet and stamper by means of an easy method using pressure rollers or easy press to temporarily bond them at temperature of 20 to 100°C, and then curing the sheet by exposing it to light at room temperature for one to tens seconds. Further, the temporarily bonded laminate is free from occurrence of slippage (sagging) or peeling between of the sheet and stamper or substrate owing to its autohesion force, and hence the laminate can be freely handled until the light-curing step.

In case the photo-curable transfer sheet of the invention is cured, it is possible to adopt, as light source used, various sources generating light in the wavelength range of from ultraviolet to visible rays. Examples of the sources include super-high-pressure, high-pressure and low-pressure mercury lamps, a chemical lamp, a xenon lamp, a halogen lamp, a mercury halogen lamp, a carbon arc lamp, and an incandescent electric lamp, and laser beam. The exposing time is generally in the range of 0.1 second to dozens seconds, preferably 0.5 second to a few seconds, depending upon kinds of the lamp and strength of light. The amount of the ultraviolet exposure preferably is not less than 300 mJ/cm².

To promote the curing, the laminate may be heated beforehand for 30 to 80°C, and then the heated laminate may be exposed to ultraviolet rays.

The invention is illustrated in detail using the following Examples.

### EXAMPLE

### [Example 1]

### <Preparation of photo-curable transfer sheet>

### (Preparation of polymer A having hydroxyl group)

### Polymer Formulation A

| | |
|---|---|
| Methyl methacrylate | 74.6 parts by weight |
| n-Butyl methacrylate | 13.2 parts by weight |
| 2-Hydroxyethyl methacrylate | 12.1 parts by weight |
| AIBN | 5 parts by weight |
| Toluene | 50 parts by weight |
| Ethyl acetate | 50 parts by weight |

A mixture of the above Formulation was heated to 70°C with moderately stirring to initiate the polymerization, and stirred at this temperature for 8 hours to provide polymer A (acrylic resin) having a hydroxyl group on its side chain. The solid content was adjusted to 36% by weight (polymer solution A).

The polymer A had Tg of 73°C and weight average molecular weight of 110,000.

### Composition Formulation A

| | |
|---|---|
| Solution A of polymer having hydroxyl group (solid content) | 100 parts by weight |
| Hexanediol diacrylate (SR238F, available from Sartomer) | 100 parts by weight |
| Trimethylol propane triacrylate (TMP-A, available from KYOEISHA CHEMICAL Co.,LTD) | 10 parts by weight |
| 2-Hydroxy-3-acryloyloxypropyl methacrylate (G-201P, available from KYOEISHA CHEMICAL Co., LTD) | 10 parts by weight |
| Diisocyanate (BXX5627, available from Toyo Ink Mfg.) | 1.5 parts by weight |
| Irgercure 651 (available from Chiba-Speciality-Chemicals) | 2.0 parts by weight |
| Hydroquinone monomethyl ether (MEHQ, available from Kawaguchi Chemical Industry Co., LTD.) | 0.05 part by weight |

The above Formulation A was homogeneously dissolved and mixed to give a mixture, which was applied onto a whole surface of an adhesion film (width: 300mm, length: 300m, thickness: 75µm; Trade name: HPE, available from Teijin DuPont Films Japan Limited) and dried to form a photo-curable transfer layer of thickness of 25µm. Subsequently, a release sheet (width: 300mm, length: 300m, thickness: 50µm; Trade name: A31, available from Teijin DuPont Films Japan Limited) is attached to the opposite side of the photo-curable transfer layer to be rolled up in the form of roll. Thus, a full-edge type roll of photo-curable transfer sheet of diameter of 260mm was prepared. The transfer layer of photo-curable transfer sheet had Tg of -25°C.

The adhesion film consists of a PET film (thickness: 75µm) and an adhesion layer (a mixture of polyester and acrylic resin, thickness: 0.2µm) thereon.

### [Example 2]

Example 1 was repeated except that the procedure for preparation of Composition Formulation A was carried out by further adding 0.1 part by weight of phosphoric acid ester (Trade name: LTP-2, available from Kawaken Fine Chemicals Co., Ltd.) to the Composition Formulation A, to prepare a full-edge type roll of photo-curable transfer sheet.

### [Example 3]

Example 1 was repeated except that the procedure for preparation of Composition Formulation A was carried out by further adding 0.1 part by weight of phosphoric acid ester (Trade name: CRODAFOS N3A, available from Croda Japan KK.) to the Composition Formulation A to prepare a full-edge type roll of photo-curable transfer sheet.

### [Example 4]

Example 1 was repeated except that the procedure for preparation of Composition Formulation A was carried out by further adding 0.1 part by weight of phosphoric acid ester (Trade name: CRODAFOS N10A, available from Croda Japan KK.) to the Composition Formulation A to prepare a full-edge type roll of photo-curable transfer sheet.

### [Example 5]

Example 1 was repeated except that the procedure for preparation of Composition Formulation A was carried out by further adding 10 parts by weight of acrylic-modified polysiloxane (Trade name: X22-1602, solid content: 100% by weight, available from Shin-Etsu Chemical Co., Ltd.) to the Composition Formulation A to prepare a full-edge type roll of photo-curable transfer sheet.

### [Example 6]

Example 1 was repeated except that the procedure for preparation of Composition Formulation A was carried out by further adding 10 parts by weight of acrylic-modified polysiloxane (Trade name: BYK-UV3500, solid content: 97% by weight, available from BYK Japan KK) to the Composition Formulation A to prepare a full-edge type roll of photo-curable transfer sheet. (1) Evaluation of photo-curable transfer sheet

### (1-1) Determination of glass transition temperature (Tg)

The sheets on the both side of the photo-curable transfer sheet are removed from the transfer sheet, and the resultant transfer sheets (layers) are cut into a size of length of 20.0mm and width of 4.0mm (thickness: 25µm) to prepare samples.

Tg of the samples are measured by use of a TMA (Thermal Mechanical Analysis) device SS6100 (available from SII Nano Technology Inc.) under the conditions of sample temperature of 30-120°C, temperature rising rate of 5°C/min. and tension of 4.9×10⁵ Pa.

The data measured under the above conditions brings about a graph of Fig. 5, and intersection of tangential line of stable region with tangential line of maximum gradient of expanding region is decided to glass transition temperature.

### (2) Preparation and evaluation of concave-convex pattern

### (2-1) Preparation of concave-convex pattern

A concave-convex pattern was prepared by using the apparatus shown in Fig. 4.

A pattern was formed on a nickel plate by using a resist (park-1, available from Toyo Gosei Co., Ltd.) according to photolithography method, whereby a mother stamper was obtained. The pattern consists of a micro pattern in the form of rib having depth of 10µm, height of 10µm, and nano pattern in the form of rib having depth of 50nm, height of 50nm.

The release sheet of the photo-curable transfer sheet obtained in Example was removed, and the photo-curable transfer sheet was transported to the apparatus shown in Fig. 4 (transportation velocity: 1.0 m/min.), further fed to the mother stamper part movable up and down and the UV lamp (i.e., therebetween) and came to a stop. The stop time generally was two seconds. At the same time of the stop, the mother stamper (part) made of nickel which has fine concave-convex pattern and which is controlled at 50°C was moved upward to bring the concave-convex pattern in contact with the surface of the photo-curable transfer sheet and pushed up the photo-curable transfer sheet by the mother stamper. At the same time, the adhesion film on the back side of the pushed photo-curable transfer layer is supported by the UV-transmission type pressure bonding part, and simultaneously the photo-curable transfer layer was exposed to light of a metal halide lamp (600mW/cm) in the UV lamp in the condition of integral light amount of 300m J/cm² from the adhesion film. Thereby, the transfer layer on which the concave-convex pattern of the nickel mother stamper was transferred was cured and thus an intermediate stamper was prepared.

Continuously, the intermediate stamper was transported to the sheet setting platform part movable up and down and a UV lamp (i.e., therebetween), and came to a stop. The stop time was two seconds. When the intermediate stamper came to the sheet setting platform, another photo-curable transfer sheet that is the same as above was placed on the sheet setting platform moved upward, and simultaneously an adhesion film on the back side of the intermediate stamper 44 which was pushed upward together with the photo-curable transfer sheet was supported by the UV-transmission type pressure bonding part. Hence the photo-curable transfer layer was compressed by the intermediate stamper, and simultaneously the photo-curable transfer layer was exposed to light of a metal halide lamp (600mW/cm) in the UV lamp in the condition of integral light amount of 300m J/cm² from the adhesion film. Thereby, the transfer layer on which the concave-convex pattern of the intermediate stamper was transferred was cured and thus a sheet having the concave-convex pattern of the mother stamper was prepared.

### [Comparison Example 1]

An intermediate stamper was prepared from the above-mentioned mother stamper by using ZEONOR film (ZF-14, available from OPTES INC.) as thermoplastic resin in the conditions of heating at 190°C for 10 minutes and cooling to 130°C for 3 minutes, and then a sheet having the concave-convex pattern of the mother stamper was prepared in the same manner as above.

### [Comparison Example 2]

Comparison Example 1 was repeated except for using PC film (Pure-Ace, available from TEIJIN CHEMICALS LTD) as thermoplastic resin to prepare a sheet having the concave-convex pattern of the mother stamper.

### (2-1) Evaluation of concave-convex pattern

(i) As for the micro pattern, the difference between the shape of the mother stamper and that of the intermediate stamper is evaluated by using a microscope.
   ⊚: The difference between the shape of the mother stamper and that of the intermediate stamper is not observed.
   O: The difference between the shape of the mother stamper and that of the intermediate stamper is little observed.
   Δ: The difference between the shape of the mother stamper and that of the intermediate stamper is a little observed.
   ×: The difference between the shape of the mother stamper and that of the intermediate stamper is observed.

(i) As for the nano pattern, the difference between the shape of the mother stamper and that of the intermediate stamper is evaluated by using a transmission electron microscope.
   ⊚: The difference between the shape of the mother stamper and that of the intermediate stamper is not observed.
   ○: The difference between the shape of the mother stamper and that of the intermediate stamper is little observed.
   Δ: The difference between the shape of the mother stamper and that of the intermediate stamper is a little observed.
   ×: The difference between the shape of the mother stamper and that of the intermediate stamper is observed.

### (2-3) Time period required for preparing concave-convex pattern

Time period stopped at each of the UV- transmission type pressure bonding parts provided with a mother stamper part and UV lamp is measured and shown as tact time.

**[Table 1]**

| | Transfer step of mother stamper | | | | Transfer step of intermediate stamper | | | |
|---|---|---|---|---|---|---|---|---|
| | Transfer pattern | | Molding conditions | | Transfer pattern | | Molding conditions | |
| | Micro | NaNo | Tact time | Temp./ Light amount | Micro | Nano | Tact time | Temp./ Light amount |
| Co. Ex. 1 | | | | | Δ | Δ | 3 min. | 190→ 130°C |
| Co. Ex. 2 | | | | | Δ | Δ | 3 min. | 190→ 130°C |
| Ex. 1 | ○ | ○ | 2 sec. | 300mJ/ cm² | ○ | ○ | 2 sec. | 300mJ/ cm² |
| Ex. 2 | ○ | ○ | 2 sec. | 300mJ/ cm² | ○ | ○ | 2 sec. | 300mJ/ cm² |
| Ex. 3 | ○ | ○ | 2 sec. | 300mJ/ cm² | ○ | ○ | 2 sec. | 300mJ/ cm² |
| Ex. 4 | ○ | ○ | 2 sec. | 300mJ/ cm² | ○ | ○ | 2 sec. | 300mJ/ cm² |
| Ex. 5 | ⊚ | ⊚ | 2 sec. | 300mJ/ cm² | ○ | ○ | 2 sec. | 300mJ/ cm² |
| Ex. 6 | ⊚ | ⊚ | 2 sec. | 300mJ/ cm² | ○ | ○ | 2 sec. | 300mJ/ cm² |

The method of the present invention (Examples 1-6) enables significant reduction of tact time compared with a conventional method for preparing fine concave-convex pattern using thermoplastic resin. Further the resultant pattern also is the same or approximately the same as that of the mother stamper, and more excellent than that obtained by the conventional method.

### Explanation of reference numbers

- 11, 21:: Photo-curable transfer layer
- 12, 22:: Adhesion film
- 12a, 22a:: Adhesion layer
- 12b, 22b:: Polymer film
- 13:: Release sheet
- 14, 24:: Stamper

## Claims

1. A method for forming a concave-convex pattern comprising of the steps (1) to (4):
a step (1) of placing a stamper having a fine concave-convex pattern surface thereon on a photo-curable transfer layer of a photo-curable transfer sheet, the photo-curable transfer sheet comprising a transparent film and the photo-curable transfer layer thereon, such that the concave-convex pattern surface of the stamper is in contact with a surface of the photo-curable transfer layer, and depressing the stamper and the photo-curable transfer sheet to form a laminate in which one side of the photo-curable transfer layer adheres closely to the concave-convex pattern surface;
a step (2) of exposing the photo-curable transfer layer of the laminate having the stamper to ultraviolet rays to cure the photo-curable transfer layer, and removing the stamper from the laminate to form an inverted pattern of the fine concave-convex pattern on a surface of the photo-curable transfer layer, the photo-curable transfer sheet having the inverted fine concave-convex pattern surface being referred to as an intermediate stamper;
a step (3) of placing the intermediate stamper on a photo-curable transfer layer of another photo-curable transfer sheet, the another photo-curable transfer sheet comprising a transparent film and the photo-curable transfer layer thereon, such that the inverted concave-convex pattern surface of the intermediate stamper is in contact with a surface of the photo-curable transfer layer of the another photo-curable transfer sheet and depressing the intermediate stamper and the another photo-curable transfer sheet to form a laminate in which one side of the another photo-curable transfer layer adheres closely to the inverted concave-convex pattern surface; and
a step (4) of exposing the photo-curable transfer layer of the laminate having the intermediate stamper to ultraviolet rays to cure the photo-curable transfer layer, and removing the intermediate stamper from the laminate to form a fine concave-convex pattern on a surface of the photo-curable transfer layer, the fine concave-convex pattern being the same as that of the stamper, whereby the photo-curable transfer sheet having the fine concave-convex pattern surface is obtained.

2. A method for forming a concave-convex pattern as defined in claim 1, wherein the placing and depressing of the step (1) and the exposing to ultraviolet rays of the step (2) are carried out at the same time, and/or the placing and depressing of the step (3) and the exposing to ultraviolet rays of the step (4) are carried out at the same time.

3. A method for forming a concave-convex pattern as defined in claim 1 or 2, wherein the photo-curable transfer layers used in the steps (1) and (3) comprise a photo-curable composition deformable by application of pressure.

4. A method for forming a concave-convex pattern as defined in any of claims 1 to 3, wherein the photo-curable transfer layer used in at least the step (1) contains a lubricant.

5. A method for forming a concave-convex pattern as defined in claim 4, wherein the lubricant is a phosphorus atom-containing compound or modified polysiloxane.

6. A method for forming a concave-convex pattern as defined in claim 5, wherein the modified polysiloxane is (meth)acryloyl group-containing polysiloxane.

7. A method for forming a concave-convex pattern as defined in any of claims 1 to 6, wherein the transparent film is a polymer film having an adhesion layer thereon.

8. A method for forming a concave-convex pattern as defined in claim 7, wherein the adhesion layer comprises at least one resin selected from polyester resin, polyurethane resin and acrylic resin.

9. A method for forming a concave-convex pattern as defined in claim 7 or 8, wherein the adhesion layer has a thickness of 0.01 to 0.3µm.

10. A method for forming a concave-convex pattern as defined in any of claims 1 to 9, wherein the photo-curable composition comprises a polymer and a reactive diluent having a photopolymerizable functional group.

11. A method for forming a concave-convex pattern as defined in any of claims 4 to 10, wherein the photo-curable composition contains the lubricant in an amount of 0.01 to 20% by weight.

12. A method for forming a concave-convex pattern as defined in any of claims 1 to 11, wherein the photo-curable composition further contains diisocyanate.

13. A method for forming a concave-convex pattern as defined in any of claims 1 to 12, wherein the photo-curable composition further contains 0.1 to 10% by weight of a photopolymerization initiator.

14. A method for forming a concave-convex pattern as defined in any of claims 1 to 13, wherein the photo-curable transfer layer has a thickness of 1 to 300µm.

15. A method for forming a concave-convex pattern as defined in any of claims 1 to 14, wherein at lease the photo-curable transfer sheet used in the step (1) is in the form of continuous length.

16. An apparatus for preparing a concave-convex pattern comprising:
a delivery means for delivering a continuous photo-curable transfer sheet comprising a continuous transparent film and a photo-curable transfer layer thereon;
a first depression means for placing a stamper having a fine concave-convex pattern surface thereon on the photo-curable transfer layer of the continuous photo-curable transfer sheet, such that the concave-convex pattern surface of the stamper is in contact with a surface of the photo-curable transfer layer, and depressing the stamper and the continuous photo-curable transfer sheet;
a first ultraviolet exposure means for exposing the photo-curable transfer layer to ultraviolet rays at the same time as the depressing to form an inverted fine concave-convex pattern on a surface of the photo-curable transfer layer, the continuous photo-curable transfer sheet having the inverted fine concave-convex pattern surface being referred to as an intermediate stamper;
a second depression means for placing the intermediate stamper on a photo-curable transfer layer of another photo-curable transfer sheet, such that the inverted concave-convex pattern surface of the intermediate stamper is in contact with a surface of the photo-curable transfer layer of the continuous another photo-curable transfer sheet and depressing the intermediate stamper and the another photo-curable transfer sheet; and
a second ultraviolet exposure means for exposing the photo-curable transfer layer to ultraviolet rays at the same time as the depressing.
